# EUROPEAN PATENT APPLICATION

(11) **EP 1 850 371 A1**
(43) Date of publication of application: **31.10.2007**
(21) Application number: 06712462.8
(22) Date of filing: 27.01.2006
(51) Int. Cl.: H01L 21/027, G03F 7/20

(54) **EXPOSURE METHOD, EXPOSURE APPARATUS AND METHOD FOR MANUFACTURING DEVICE**

(30) Priority: 31.01.2005 JP 2005023244
(71) Applicant: NIKON CORPORATION, Tokyo 100-8331 (JP)
(72) Inventor: SHIRAISHI, Kenichi c/o NIKON CORPORATION, Intellectual Prop. Dep., Chiyoda-ku, Tokyo (JP)
(74) Representative: HOFFMANN EITLE
(86) International application number: PCT/JP2006/301296
(87) International publication number: WO 2006/080427

(57) **Abstract**

An exposure condition is determined in accordance with a moving condition of a substrate (P) relative to a projection optical system so that a pattern image is projected on the substrate (P) in a desired projection state, and the substrate (P) is exposed in the determined exposure condition.

## Description

### TECHNICAL FIELD

The present invention is related to an exposure method, an exposure apparatus and a method for fabricating a device, which are for exposing a substrate through liquid.

This application claims the benefit of Japanese Patent Application No. 2005-023244 filed on January 31, 2005, the disclosure of which is incorporated herein by reference.

### BACKGROUND ART

In a photolithography process, one of the processes for fabricating a micro device such as a semiconductor device and liquid crystal device, use is made of an exposure apparatus that projects a pattern image formed on a mask to a photosensitive substrate. The exposure apparatus includes a mask stage which supports a mask and a substrate stage which supports a substrate. The exposure apparatus is adapted to project an image of a pattern of the mask on the substrate through a projection optical system while sequentially moving the mask stage and the substrate stage. In the manufacture of micro devices, miniaturization of a pattern formed on the substrate is required to increase density of the devices. In order to comply with such a requirement, there is a need to further enhance a resolution power of the exposure apparatus. As means for assuring the enhanced resolution power, there has been proposed a liquid immersion exposure apparatus that performs an exposing process that fills a space between a projection optical system and a substrate with a liquid having a refractive index greater than that of a gas, as disclosed in Patent Document 1 below.

Patent Document 1: PCT International Publication No. WO 99/49504.

### DISCLOSURE OF INVENTION

### PROBLEMS TO BE SOLVED BY THE INVENTION

At the time when the substrate (substrate stage) is moved relative to the projection optical system in a state where liquid is filled between the projection optical system and the substrate, there is a possibility that a desired pattern image cannot be projected through the liquid due to variations in temperature or a temperature distribution of the liquid.

The present invention has been made in view of such circumstances, and it is an object of the present invention to provide an exposure method, an exposure apparatus and a method for fabricating a device, which are capable of projecting a pattern image on a substrate in a desired projection state.

### MEANS FOR SOLVING THE PROBLEM

In order to achieve these objects, the present invention employs the following configurations summarized below in conjunction with the drawings that illustrate embodiments. In this regard, reference numerals in parentheses are attached to individual elements merely for the purpose of illustration and are not intended to limit the respective elements.

In accordance with a first aspect of the present invention, there is provided an exposure method for exposing a substrate by filling liquid (LQ) in a light path space (K1) formed between a projection optical system (PL) and the substrate (P) and projecting a pattern image on the substrate through the projection optical system (PL) and the liquid (LQ). The exposure method includes: determining an exposure condition in accordance with a moving condition of the substrate (P) relative to the projection optical system (PL) so that the pattern image is projected on the substrate (P) in a desired projection state; and exposing the substrate (P) in the determined exposure condition.

In accordance with the first aspect of the present invention, it may be possible to project the pattern image in a desired projection state by determining the exposure condition based on the moving condition of the substrate relative to the projection optical system.

In accordance with a second aspect of the present invention, there is provided an exposure apparatus (EX) for exposing a substrate (P) by filling liquid (LQ) in a light path space (K1) formed between a projection optical system (PL) and the substrate (P) and projecting a pattern image on the substrate (P) through the projection optical system (PL) and the liquid (LQ). The exposure apparatus (EX) includes: a movable member capable of holding and moving the substrate (P) at an image plane side of the projection optical system (PL); and a storage device (MRY) that pre-stores an exposure condition for projecting the pattern image on the substrate (P) in a desired projection state in accordance with a moving condition of the substrate (P) relative to the projection optical system (PL).

In accordance with the second aspect of the present invention, with the provision of the storage device that pre-stores the exposure condition for projecting the pattern image on the substrate in a desired projection state in accordance with the moving condition of the substrate relative to the projection optical system, it may be possible to project the pattern image on the substrate in a desired projection state by use of the information thus stored.

In accordance with a third aspect of the present invention, there is provided a method for fabricating a device that makes use of the exposure apparatus (EX) of the configuration as noted above.

In accordance with the third aspect of the present invention, a pattern image may be projected on a substrate in a desired projection state.

### EFFECTS OF THE INVENTION

In accordance with the present invention, a pattern image can be projected on a substrate in a desired projection state, which makes it possible to manufacture a device of desired performance.

### BRIEF DESCRIPTION OF THE DRAWINGS

FIG. 1 is a schematic diagram showing an embodiment of an exposure apparatus.
FIG. 2 is a plan view illustrating a substrate stage that holds a substrate in place.
FIG. 3A is a schematic diagram for explaining an influence of a positional relationship between the liquid present in a light path space and the substrate stage on the liquid.
FIG. 3B is a schematic diagram for explaining the influence of the positional relationship between the liquid present in a light path space and the substrate stage on the liquid.
FIG. 4A is a schematic diagram illustrating a state that a shot region on the substrate undergoes a scan-exposure.
FIG 4B is a schematic diagram illustrating a state that a shot region on the substrate undergoes a scan-exposure.
FIG. 5 is a flowchart for explaining an embodiment of an exposure method.
FIG. 6A is a view for explaining an aberration caused by the temperature of liquid.
FIG. 6B is a view for explaining an aberration caused by the temperature of liquid.
FIG. 6C is a view for explaining an aberration caused by the temperature of liquid.
FIG 7A is a view for explaining an aberration caused by the temperature of liquid.
FIG. 7B is a view for explaining an aberration caused by the temperature of liquid.
FIG. 8 is a view for explaining temperature sensors provided on a dummy substrate.
FIG. 9 is a flowchart for explaining an example of a process for fabricating a micro device.

### DESCRIPTION OF THE REFERENCE SYMBOLS

10: LIQUID SUPPLY MECHANISM, 20: LIQUID RECOVERY MECHANISM, 100: LIQUID IMMERSION MECHANISM, AR: PROJECTION REGION, CONT: CONTROL UNIT, EX: EXPOSURE APPARATUS, K1: LIGHT PATH SPACE, LC: IMAGING CHARACTERISTIC ADJUSTMENT UNIT, LQ: LIQUID, LR: LIQUID IMMERSION REGION, MRY: STORAGE UNIT, P: SUBSTRATE, PL: PROJECTION OPTICAL SYSTEM, PST: SUBSTRATE STAGE, PSTD: SUBSTRATE STAGE DRIVE UNIT, S1-S32: SHOT REGION

### BEST MODE FOR CARRYING OUT THE INVENTION

Hereinbelow, embodiments of the present invention will be described with reference to the accompanying drawings, but the present invention will not be limited to these embodiments.

### <Exposure Apparatus>

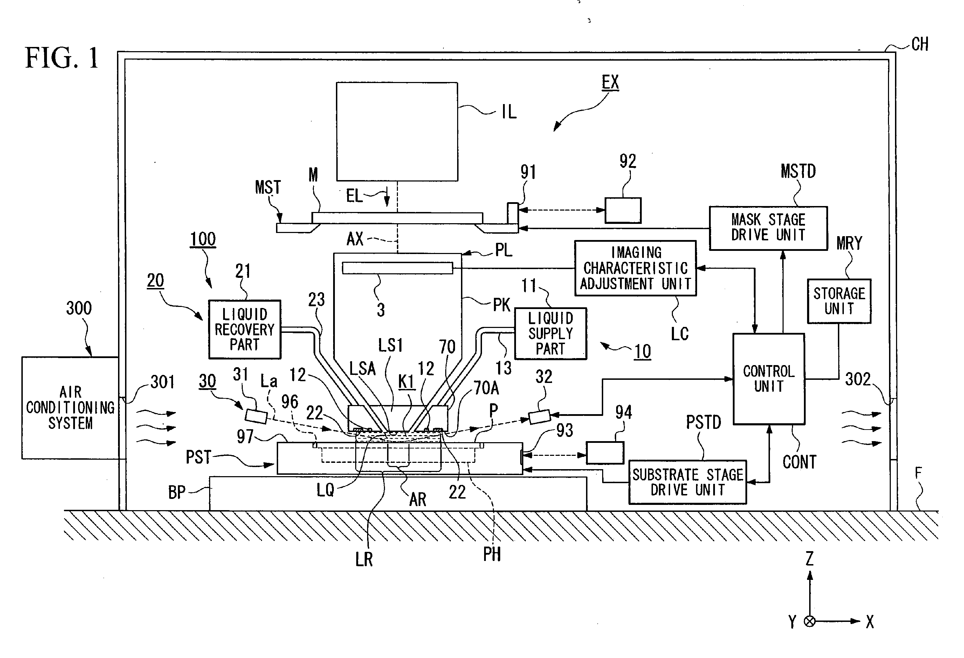

First of all, an embodiment of an exposure apparatus will be described with reference to FIG. 1, which is a schematic diagram showing an embodiment of the exposure apparatus EX. In FIG. 1, the exposure apparatus EX includes a mask stage MST for holding and moving a mask M, a substrate stage PST having a substrate holder PH for holding a substrate P, the substrate stage PST capable of moving the substrate holder PH that holds the substrate P, an illumination optical system IL for illuminating exposure light EL on the mask M held by the mask stage MST, a projection optical system PL for projecting a pattern image of the mask M illuminated with the exposure light EL on the substrate P, a control unit CONT for generally controlling overall operations of the exposure apparatus EX, and a storage unit MRY connected to the control unit CONT for storing various exposure information.

The exposure apparatus EX of the present embodiment is a liquid immersion exposure apparatus that makes use of a liquid immersion method for the purpose of substantially shortening an exposure wavelength to thereby increase a resolution power and substantially broaden a depth of focus. The exposure apparatus EX is provided with a liquid immersion mechanism 100 for filling liquid LQ in a light path space K1 of the exposure light EL on an image plane side of the projection optical system PL. The liquid immersion mechanism 100 includes a nozzle member 70 arranged in the vicinity of an image plane of the projection optical system PL and having supply ports 12 for supply of the liquid LQ and recovery ports 22 for recovery of the liquid LQ, a liquid supply mechanism 10 for supplying the liquid LQ to the image plane side of the projection optical system PL through the supply ports 12 of the nozzle member 70, and a liquid recovery mechanism 20 for recovering the liquid LQ on the image plane side of the projection optical system PL through the recovery ports 22 of the nozzle member 70. The nozzle member 70 is arranged above the substrate P (substrate stage PST) and formed in an annular shape so as to enclose a first optical element LS 1 lying nearest to the image plane of the projection optical system PL among a plurality of optical elements in the projection optical system PL.

The exposure apparatus EX adopts a local immersion method by which, while the pattern image of the mask M is being projected on the substrate P, a liquid immersion region LR of the liquid LQ that is larger than a projection region AR but smaller than the substrate P is locally formed on a part of the substrate P, including the projection region AR of the projection optical system PL, by use of the liquid LQ supplied from the liquid supply mechanism 10. More specifically, in the exposure apparatus EX, the liquid LQ is filled into the light path space K1 of the exposure light EL between a lower surface LSA of the first optical element LS1 closest to the image plane of the projection optical system PL and the substrate P arranged at the image plane side of the projection optical system PL. The substrate P is exposed by projecting the pattern image of the mask M on the substrate P via the projection optical system PL and the liquid LQ filling the space formed between the projection optical system PL and the substrate P. The control unit CONT is adapted to locally form the liquid immersion region LR of the liquid LQ on the substrate P by supplying a prescribed quantity of the liquid LQ to the substrate P with the liquid supply mechanism 10 and recovering a prescribed quantity of the liquid LQ on the substrate P with the liquid recovery mechanism 20.

In the present embodiment, description will be made based on an exemplary case wherein, as the exposure apparatus EX, use is made of a scan type exposure apparatus (what is called a scanning stepper) that projects the pattern image of the mask M on the substrate P while synchronously moving the mask M and the substrate P in the respective scanning directions (opposite directions). In the following description, the synchronous moving direction (scanning direction) of the mask M and the substrate P within a horizontal plane will be referred to as a Y-axis direction, the direction orthogonal to the Y-axis direction within the horizontal plane will be referred to as an X-axis direction (non-scanning direction), and the direction perpendicular to the Y-axis and X-axis directions and coinciding with an optical axis AX of the projection optical system PL will be referred to as a Z-axis direction. Furthermore, the rotational (oblique) directions about the X-axis, Y-axis and Z-axis directions will be referred to as θX, θY and θZ directions, respectively. Moreover, the term "substrate" used herein includes a base member, such as a semiconductor wafer or the like, which is coated with a photosensitive material (resist), and the term "mask" includes a reticle formed with a device pattern which is to be reduction-projected on the substrate.

As shown in FIG. 1, the exposure apparatus EX is accommodated in a chamber apparatus CH. The chamber apparatus CH is installed on a floor surface F within a clean room. The internal space of the chamber apparatus CH that accommodates the exposure apparatus EX is air-conditioned by means of an air conditioning system 300. The air conditioning system 300 serves to keep the environment in the internal space of the chamber apparatus CH (including the degree of cleanliness, the temperature, the humidity and the pressure) in a desired state. The air conditioning system 300 used in the present embodiment is adapted to maintain the environment in the internal space of the chamber apparatus CH by supplying a gas conditioned in a desired state to the internal space of the chamber apparatus CH through a gas supply port 301 provided in one portion of the chamber apparatus CH, while discharging the gas from the internal space of the chamber apparatus CH to the outside through a gas exhaust port 302 provided in the other portion of the chamber apparatus CH. Although the chamber apparatus CH shown in FIG. 1 is configured to accommodate the exposure apparatus EX in its entirety, it may be constructed such that it accommodates not the whole parts of the exposure apparatus EX but only a part of the exposure apparatus EX including the light path space K1. The air conditioning system 300 of the present embodiment is designed to air-condition at least the vicinity of the light path space K1.

Moreover, the positions of the gas supply port 301 and the gas exhaust port 302 are not restricted to the ones illustrated in FIG. 1. As an alternative example, the gas supply port 301 may be provided in an upper portion of the chamber apparatus CH and the gas exhaust port 302 may be provided in a lower portion of the chamber apparatus CH.

The illumination optical system IL includes an exposure light source, an optical integrator for making the illuminance of light beams projected from the exposure light source uniform, a condenser lens for collecting exposure light EL from the optical integrator, a relay lens array, a field stop for setting an illumination region of the exposure light EL on the mask M, and so forth. The illumination optical system IL is adapted to illuminate the illumination region on the mask M with the exposure light EL of a uniform luminous flux intensity distribution. As the exposure light EL emitted from the illumination optical system IL, use is made of, e.g., deep ultraviolet light (DUV light) such as emission lines (a g-line, a h-line and an i-line) emitted from a mercury lamp, KrF excimer laser light (with a wavelength of 248nm) or the like and vacuum ultraviolet light (VUV light) such as ArF excimer laser light (with a wavelength of 193nm), F₂ laser light (with a wavelength of 157nm) or the like. The ArF excimer laser light is utilized in the present embodiment.

In the present embodiment, pure or purified water is used as the liquid LQ supplied from the liquid supply mechanism 10. The pure water permits transmission of, e.g., deep ultraviolet light (DUV light) such as emission lines (a g-line, a h-line and an i-line) emitted from a mercury lamp, KrF excimer laser light (with a wavelength of 248nm) or the like, as well as ArF excimer laser light.

The mask stage MST is capable of holding and moving the mask M. The mask stage MST is adapted to hold the mask M by vacuum suction (or electrostatic attraction). While holding the mask M in place, the mask stage MST can be two-dimensionally moved within a plane perpendicular to the optical axis AX of the projection optical system PL, i.e., within an X-Y plane and also can be finely rotated in the θZ direction by means of a mask stage drive unit MSTD, including a linear motor or a voice coil motor, controlled by the control unit CONT. A movable mirror 91 is provided at the mask stage MST and a laser interferometer 92 is provided at a position oppositely facing the movable mirror 91. The position in the two-dimensional direction and the rotation angle in the θZ direction (possibly including rotation angles in the θX and θY directions) of the mask M placed on the mask stage MST are measured by means of the laser interferometer 92 on a real time basis. The measurement result from the laser interferometer 92 is outputted to the control unit CONT. Based on the measurement result from the laser interferometer 92, the control unit CONT operates the mask stage drive unit MSTD and controls the position of the mask M held in place on the mask stage MST.

The projection optical system PL is adapted to project the pattern image of the mask M on the substrate P with a predetermined projection magnification ratio β. The projection optical system PL has a plurality of optical elements including a first optical element LS1, wherein the optical elements are kept in place by a lens barrel PK. In the present embodiment, the projection optical system PL is a reduction system whose projection magnification ratio β is equal to, e.g., 1/4, 1/5 or 1/8. Alternatively, the projection optical system PL may be either an equal magnification system or an enlargement system. Furthermore, the projection optical system PL may be any one of a dioptric system with no reflection element, a catoptric system with no refraction element and a catadioptric system including a reflection element and a refraction element. Moreover, in the present embodiment, among the plurality of optical elements in the projection optical system PL, the first optical element LS1 closest to the image plane of the projection optical system PL is exposed to the outside from the lens barrel PK.

The projection optical system PL is provided with an imaging characteristic adjustment unit LC capable of adjusting imaging characteristics of the projection optical system PL, as disclosed in, e.g., Japanese Patent Application, Publication Nos. S60-78454 and H11-195602 and PCT International Publication No. WO 03/65428. The imaging characteristic adjustment unit LC includes an optical element drive unit 3 capable of moving some of the plurality of optical elements in the projection optical system PL. The optical element drive unit 3 can make specified ones among the plurality of optical elements in the projection optical system PL be moved in a direction of the optical axis AX (Z-axis direction) or be inclined relative to the optical axis AX. By moving specified ones among the plurality of optical elements in the projection optical system PL, the imaging characteristic adjustment unit LC can adjust the imaging characteristics including various aberrations (e.g., a projection magnification ratio, a distortion and a spherical aberration) and an image surface position (focus position) of the projection optical system PL. Furthermore, as the imaging characteristic adjustment unit LC, it may be possible to include a pressure regulating mechanism for regulating the pressure of a gas present in a space between some of the optical elements held within the lens barrel PK. The imaging characteristic adjustment unit LC is controlled by the control unit CONT.

The substrate stage PST carries the substrate holder PH for holding the substrate P and is movable along a base member BP at the image plane side of the projection optical system PL. The substrate holder PH is adapted to hold the substrate P by means of, e.g., vacuum suction. A recess portion 96 is provided on the substrate stage PST, and the substrate holder PH for holding the substrate P is arranged in the recess portion 96. And, the upper surface 97 of the substrate stage PST around the recess portion 96 is formed into a planar surface (planar portion) having substantially the same height as (or flush with) the surface of the substrate P held in the substrate holder PH.

Holding the substrate P by use of the substrate holder PH, the substrate stage PST can be two-dimensionally moved along the base member BP within an X-Y plane and also can be finely rotated in a θZ direction by means of a substrate stage drive unit PSTD, including a linear motor or a voice coil motor, controlled by the control unit CONT. In addition, the substrate stage PST is movable in Z-axis, θX and θY directions. Thus, the surface of the substrate P supported on the substrate stage PST can be moved with six degrees of freedom of movement in the X-axis, Y-axis, Z-axis, θX, θY and θZ directions. A movable mirror 93 is provided on a side surface of the substrate stage PST and a laser interferometer 94 is provided at a position oppositely facing the movable mirror 93. The two-dimensional direction position of the substrate P placed on the substrate stage PST and the rotation angle thereof are measured by means of the laser interferometer 94 on a real time basis.

The exposure apparatus EX further includes an oblique incidence type focus leveling detection system 30 for detecting information on the surface position of the substrate P supported on the substrate stage PST, as disclosed in, e.g., Japanese Patent Application, Publication No. H08-37149. The focus leveling detection system 30 includes a projector portion 31 for irradiating detection light La on the surface of the substrate P in an oblique direction and a light receiving portion 32 provided in a given positional relationship with the detection light La for receiving reflection light of the detection light La irradiated on the surface of the substrate P, wherein the reflection light is the light reflected from the surface of the substrate P. Based on the results of light reception in the light receiving portion 32, the focus leveling detection system 30 detects information on the surface position of the substrate P (positional information in the Z-axis direction and inclination information in the θX and θY directions).

The measurement result of the laser interferometer 94 is outputted to the control unit CONT. Based on the measurement result from the laser interferometer 94, the control unit CONT controls the position of the substrate P in the X-axis, Y-axis and θZ directions. The results of detection from the focus leveling detection system 30 are also outputted to the control unit CONT. Based on the results of detection from the focus leveling detection system 30, and the like, the control unit CONT is adapted to control the position of the surface of the substrate P by operating the substrate stage drive unit PSTD and controlling the focus position (Z-axis position) and the inclination angles(θX and θY).

Next, description will be made on the liquid supply mechanism 10 and the liquid recovery mechanism 20 of the liquid immersion mechanism 100. The liquid supply mechanism 10 is used to supply the liquid LQ to the image plane side of the projection optical system PL and includes a liquid supply part 11 for feeding the liquid LQ and a supply pipe 13 connected at one end thereof to the liquid supply part 11. The supply pipe 13 is connected at the other end thereof to the nozzle member 70. Inside the nozzle member 70, there is formed an internal flow path (supply flow path) that interconnects the other end of the supply pipe 13 and the supply ports 12. The liquid supply part 11 includes a tank for storing the liquid LQ, a compression pump, a temperature control unit for controlling the temperature of the liquid LQ supplied, a filter unit for removing foreign materials or matters present in the liquid LQ, and so forth. The liquid supplying operation of the liquid supply part 11 is controlled by the control unit CONT. Furthermore, the exposure apparatus EX need not be equipped with the tank, the compression pump, the temperature control unit and the filter unit of the liquid supply mechanism 10 in their entirety. Facilities existing in a factory in which the exposure apparatus EX is installed may be utilized in place thereof.

The liquid recovery mechanism 20 serves to recover the liquid LQ present on the image plane side of the projection optical system PL. The liquid recovery mechanism 20 includes a liquid recovery part 21 for recovering the liquid LQ and a recovery pipe 23 connected at one end thereof to the liquid recovery part 21. The recovery pipe 23 is connected at the other end thereof to the nozzle member 70. Inside the nozzle member 70, there is formed an internal flow path (recovery flow path) that interconnects the other end of the recovery pipe 23 and the recovery ports 22. The liquid recovery part 21 includes a vacuum system (suction device) such as a vacuum pump or the like, a gas-liquid separator for separating the liquid LQ and the gas recovered, a tank for storing the thus-recovered liquid LQ, and so forth. The exposure apparatus EX needs not be equipped with the vacuum system, the gas-liquid separator and the tank of the liquid recovery mechanism 20 in their entirety. Facilities existing in a factory in which the exposure apparatus EX is installed may be utilized in place thereof.

The supply ports 12 for supply of the liquid LQ and the recovery ports 22 for recovery of the liquid LQ are formed on a lower surface 70A of the nozzle member 70. The lower surface 70A of the nozzle member 70 is provided in such a position as to face the surface of the substrate P and the upper surface 97 of the substrate stage PST. The nozzle member 70 is an annular member adapted to enclose a flank surface of the first optical element LS1. The supply ports 12 are provided in plural numbers on the lower surface 70A of the nozzle member 70 so that they can surround the first optical element LS1 of the projection optical system PL (the optical axis AX of the projection optical system PL). Moreover, the recovery ports 22 are provided on the lower surface 70A of the nozzle member 70 at positions located more outwardly than the supply ports 12 with respect to the first optical element LS 1 so that they can surround the first optical element LS 1 and the supply ports 12.

And, the control unit CONT is adapted to fill the liquid LQ in the light path space K1 of the exposure light EL between the projection optical system PL and the substrate P and to locally form the liquid immersion region LR of the liquid LQ on the substrate P, by supplying a prescribed quantity of the liquid LQ to the substrate P with the liquid supply mechanism 10 and recovering a prescribed quantity of the liquid LQ present on the substrate P through the use of the liquid recovery mechanism 20. At the time of forming the liquid immersion region LR of the liquid LQ, the control unit CONT operates both the liquid supply part 11 and the liquid recovery part 21. Outputted from the liquid supply part 11 under the control of the control unit CONT, the liquid LQ flows through the supply pipe 13, after which the liquid LQ is fed to the image plane side of the projection optical system PL from the supply ports 12 via the supply flow path of the nozzle member 70. Furthermore, if the liquid recovery part 21 is operated under the control of the control unit CONT, the liquid LQ at the image plane side of the projection optical system PL is introduced into the recovery flow path of the nozzle member 70 through the recovery ports 22 and is then collected in the liquid recovery part 21 through the recovery pipe 23.

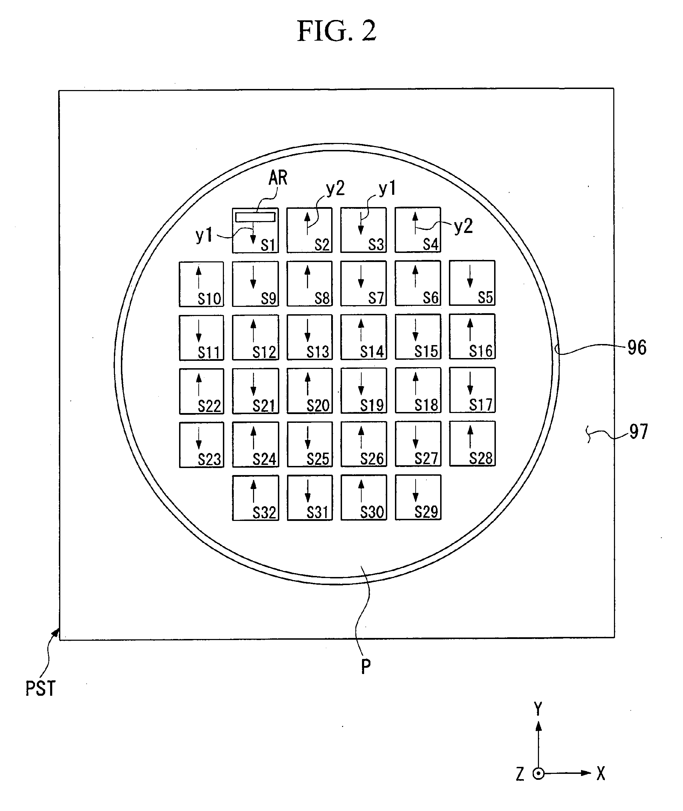

FIG. 2 is a top plan view showing the substrate stage PST that holds the substrate P in place. As shown in FIG. 2, a plurality of shot regions S1-S32 is defined on the substrate P in a matrix shape and is subject to exposure one after another. The control unit CONT is adapted to cause relative movement of the projection optical system PL and the substrate P (substrate stage PST) in the Y-axis direction, thereby scan-exposing the respective shot regions S1-S32. As can be seen in FIG. 2, the projection region AR of the projection optical system PL employed in the present embodiment has a slit-like shape (rectangular shape) whose long side extends in the X-axis direction. The control unit CONT scan-exposes the respective shot regions S1-532, while causing relative movement of the projection region AR of the projection optical system PL and the respective shot regions S1-S32 of the substrate P in the directions indicated by arrows y1 and y2 in FIG 2.

In the present embodiment, the control unit CONT is adapted to initially scan-expose a first shot region S1 among the plurality of shot regions S1-S32 defined on the substrate P. During the course of exposing the first shot region S1, the control unit CONT allows the first shot region S1 to move into a scan start position and, at the same time, causes movement of the substrate P (substrate stage PST) so that the projection region AR and the first shot region S1 can be relatively moved in the direction indicated by the arrow y1, thus scan-exposing the first shot region S1. After the first shot region S1 has been scan-exposed, the control unit CONT allows the projection optical system PL and the substrate P (substrate stage PST) to make relative stepping movement in the X-axis direction to thereby scan-expose a second shot region S2. The control unit CONT gives rise to stepping movement of the substrate P to thereby bring the second shot region S2 into a scan start position and, at the same time, causes movement of the substrate P (substrate stage PST) so that the projection region AR and the second shot region S2 can be relatively moved in the direction indicated by the arrow y2, thus scan-exposing the second shot region S2. After the second shot region S2 has been scan-exposed, the control unit CONT allows the projection optical system PL and the substrate P (substrate stage PST) to make relative stepping movement in the X-axis direction to thereby scan-expose a third shot region S3. In a similar manner, the control unit CONT continues to scan-expose one of the remaining shot regions and then brings the next shot region into a scan start position by causing stepping movement of the substrate P, whereby the first to thirty second shot regions S1-S32 are exposed one after another while moving the substrate P by a step-and-scan method.

At the time of scan-exposing each of the shot regions, the control unit CONT brings the corresponding shot region to a scan start position and drives the substrate P (substrate stage PST) so that the shot region can be displaced in the Y-axis direction while sequentially going through an accelerated state in which the shot region is speeded up, a steady or stable state in which the shot region is moved at a constant speed and a decelerated state in which the shot region is slowed down. The task of scan-exposing the substrate P is performed in the steady state, during which time a pattern image for a portion of the mask M lying within the illumination region of the exposure light EL is projected on the slit-like (rectangular) projection region AR of the projection optical system PL. Moreover, in the steady state noted above, in synchronism with the movement of the mask M relative to the projection optical system PL in a -Y direction (or a +Y direction) at a speed of V, the substrate P is moved in the +Y direction (or the -Y direction) at a speed of β·V (where β stands for a projection magnification ratio).

During the time when the respective shot regions S1-S32 on the substrate P are subject to liquid immersion exposure, the control unit CONT fills the liquid LQ in the light path space K1 of the exposure light EL formed between the projection optical system PL and the substrate P on the substrate stage PST by use of the liquid immersion mechanism 100, thereby forming the liquid immersion region LR of the liquid LQ larger in size than the projection region AR. Then, in a state that the projection region AR is covered with the liquid immersion region LR of the liquid LQ, the control unit CONT exposes the substrate P by irradiating the exposure light EL thereon, which has passed the mask M, on the substrate P through the projection optical system PL and the liquid LQ.

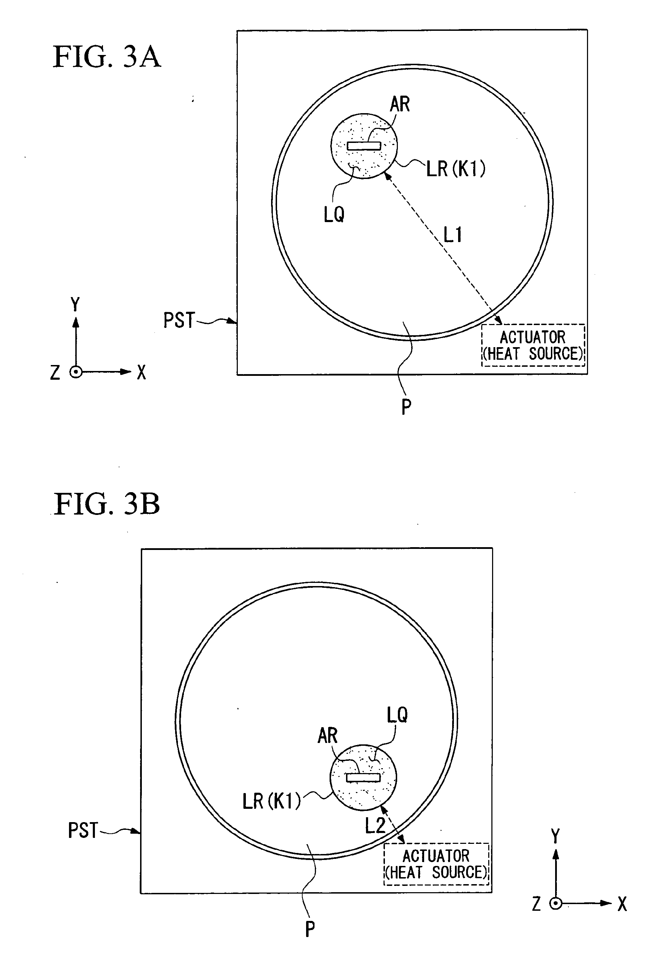

FIGS. 3A and 3B are schematic diagrams for explaining the influence of the positional relationship between the liquid LQ present in the light path space K1 (liquid immersion region LR) and the substrate stage PST on the liquid LQ. As illustrated in FIGS. 3A and 3B, the projection region AR remains covered with the liquid immersion region LR of the liquid LQ during the time when the respective shot regions S1-S32 on the substrate P are subject to liquid immersion exposure.

As described above, the substrate stage PST holds and moves the substrate P at the image plane side of the projection optical system PL by use of the substrate stage drive unit PSTD, including, e.g., a linear motor, a voice coil motor and the like. If actuators such as the linear motor and the voice coil motor emit heat, there is a possibility that at least one of the temperature and temperature distribution of the liquid LQ in the light path space K1 undergoes a change. That is to say, the actuators provided in the substrate stage PST serve as a heat source that changes the temperature of the liquid LQ in the light path space K1. In other words, the substrate stage PST is moved together with the heat source that causes a change in the temperature of the liquid LQ in the light path space K1. This means that the substrate P on the substrate stage PST is moved together with the heat source that causes a change in the temperature of the liquid LQ in the light path space K1.

For the sake of simplicity, it is supposed that the actuators as the heat source are arranged in a given position, e.g., in a lower right corner portion of the substrate stage PST in FIGS. 3A and 3B. The influence on the liquid LQ of the light path space K1 exercised by the heat source (actuators) in the event that, as illustrated in FIG. 3A, a given region of, e.g., an upper left portion of the substrate P (e.g., a ninth shot region S9) in the drawings is exposed by use of the substrate stage PST may possibly differ from the influence exercised in the event that, as illustrated in FIG. 3B, a given region of, e.g., a lower right portion of the substrate P (e.g., a twenty seventh shot region S27) is exposed by use of the substrate stage PST. That is to say, since the relative positional relationship between the liquid LQ of the light path space K1 (liquid immersion region LR) and the heat source (actuators) in the state illustrated in FIG. 3A differs from their relative positional relationship in the state illustrated in FIG. 3B, there is a possibility that the influence on the liquid LQ of the light path space K1 (liquid immersion region LR) exercised by the heat source (actuators) becomes different from each other.

More specifically, the distance L1 in the horizontal direction between the liquid LQ of the liquid immersion region LR and the heat source in the state illustrated in FIG. 3A differs from the distance L2 in the horizontal direction between the liquid LQ of the liquid immersion region LR and the heat source in the state illustrated in FIG. 3B. Due to the difference in distance (positional relationship), there is a possibility that at least one of the temperature and temperature distribution of the liquid LQ filled in the light path space K1 in the state shown in FIG 3A is different from that in the state depicted in FIG. 3B. That is to say, since the distance between the liquid LQ of the liquid immersion region LR and the heat source is smaller in the state shown in FIG. 3B than in the state depicted in FIG. 3A, the liquid LQ of the liquid immersion region LR in the state shown in FIG. 3B is more susceptible to the heat source than is the liquid LQ of the liquid immersion region LR in the state depicted in FIG. 3A, which may possibly increase the temperature of the liquid LQ or may make the temperature distribution conspicuous. Particularly, in case the liquid LQ in the light path space K1 (liquid immersion region LR) and the heat source lie in horizontally deviated positions as illustrated in FIGS. 3A and 3B, there is a possibility that a horizontal temperature distribution is developed in the liquid LQ of the light path space K1 (liquid immersion region LR). Moreover, in case the heat source (actuators) is arranged, e.g., below the liquid immersion region LR, there is a possibility that a vertical temperature distribution is developed in the liquid LQ of the light path space K1 (liquid immersion region LR).

For the purpose of simplicity, the above description has been made on the assumption that a single actuator as the heat source is arranged in a given position of the substrate stage PST (in a lower right corner in FIGS. 3A and 3B). However, it is true in practice that actuators are arranged in a plurality of prescribed positions of the substrate stage PST.

Since the liquid LQ is filled in the light path space K1 at the image plane side of the projection optical system PL in the present embodiment, at least one of the temperature and temperature distribution of the liquid LQ in the light path space K1 is changed depending on the positional relationship between the projection optical system PL and the heat source provided in the substrate stage PST. Furthermore, due to the fact that the substrate stage PST carrying the heat source is adapted to hold and move the substrate P, at least one of the temperature and temperature distribution of the liquid LQ in the light path space K1 is changed depending on the positional relationship between the projection optical system PL and the substrate P (substrate stage PST).

There is also a possibility that, depending on the moving direction of the substrate stage PST, at least one of the temperature and temperature distribution of the liquid LQ in the light path space K1 is changed by the heat source (actuators) equipped in the substrate stage PST. For example, an X-axis displacement actuator for moving the substrate stage PST in the X-axis direction is operated in case the substrate stage PST is to be moved in the X-axis direction. A Y-axis displacement actuator for moving the substrate stage PST in the Y-axis direction is operated in case the substrate stage PST is to be moved in the Y-axis direction. A Z-axis displacement actuator for moving the substrate stage PST in the Z-axis direction is operated in case the substrate stage PST is to be moved in the Z-axis direction. In this way, at least one of the actuators is used depending on the moving direction of the substrate stage PST. And, in case the X-axis, Y-axis and Z-axis displacement actuators are arranged in different positions and heat is generated with the operation of each of the X-axis, Y-axis and Z-axis displacement actuators, the influence on at least one of the temperature and temperature distribution of the liquid LQ will change depending on the moving direction of the substrate stage PST. As noted above, there is a possibility that at least one of the temperature and temperature distribution of the liquid LQ in the light path space K1 undergoes a change depending on the moving direction of the substrate P (substrate stage PST) that moves together with the heat source.

There is also a possibility that, depending on the moving speed of the substrate stage PST, at least one of the temperature and temperature distribution of the liquid LQ in the light path space K1 is changed by the heat source (actuators) equipped in the substrate stage PST. For example, the quantity of heat generated by the Y-axis displacement actuator becomes great in the event that the substrate stage PST is moved at a high speed (acceleration) in a prescribed direction (e.g., in the Y-axis direction), whereas the quantity of heat generated by the Y-axis displacement actuator becomes small in the event that the substrate stage PST is moved at a relatively low speed (acceleration). Moreover, as set forth above, the substrate stage PST goes through the accelerated state, the normal state and the decelerated state during the process of scan-exposing one of the shot regions. There is a possibility that the quantity of heat generated by the actuators varies with the moving state. Furthermore, in case the shot regions are scan-exposed by causing relative movement of the projection optical system PL and the substrate P, there is a possibility that the quantity of heat generated by the actuators varies with the scanning speed. In addition, there is a possibility that the quantity of heat generated by the actuators is changed depending on the stepping speed at the time when the projection optical system PL and the substrate P are relatively moved to expose the second shot region after exposure of the first shot region among the plurality of shot regions. In this way, the quantity of heat generated by the actuators may possibly be changed depending on the moving speed of the substrate P (substrate stage PST) including the scanning speed, the stepping speed, the acceleration, the deceleration and the like, thereby changing at least one of the temperature and temperature distribution of the liquid LQ in the light path space K1.

Furthermore, although at least the light path space K1 of the exposure apparatus EX is air-conditioned by means of the air conditioning system 300 as described above, there still remains a possibility that the flow state of a gas (air-conditioning state) in the vicinity of the light path space K1 varies with the positional relationship between the projection optical system PL and the substrate stage PST, the moving direction of the substrate stage PST relative to the projection optical system PL and the moving speed of the substrate stage PST relative to the projection optical system PL, thereby changing at least one of the temperature and temperature distribution of the liquid LQ in the light path space K1. For example, there is a possibility that, depending on the position of the substrate stage PST, at least one of the temperature and temperature distribution of the liquid LQ in the light path space K1 is changed by the flow interruption or the flow velocity fluctuation of a gas flowing from the gas supply port 301 toward the light path space K1. Further, there is a possibility that, depending on the position and/or the moving direction of the substrate stage PST, the gas supplied from the gas supply port 301 passes the vicinity of the heat source on the substrate stage PST before reaching the light path space K1. This increases the possibility that at least one of the temperature and temperature distribution of the liquid LQ in the light path space K1 undergoes a change. Moreover, in case the gas, which has passed the vicinity of the heat source on the substrate stage PST, arrives near the light path space K1, since the quantity of heat generated by the heat source (actuators) varies with the change in the moving speed of the substrate stage PST, there is a possibility that at least one of the temperature and temperature distribution of the liquid LQ in the light path space K1 is changed depending on the moving speed of the substrate stage PST. In this way, at least one of the temperature and temperature distribution of the liquid LQ in the light path space K1 may possibly be changed depending on the moving conditions of the substrate P (substrate stage PST) relative to the gas flow, including at least one of the positional relationship between the substrate P (substrate stage PST) and the gas flow generated by the air conditioning system 300 for air-conditioning the light path space K1 on the image plane side of the projection optical system PL, the moving direction of the substrate P (substrate stage PST) with respect to the gas flow, and the moving speed of the substrate P (substrate stage PST) relative to the gas flow.

Although the actuators have been described herein as one example of the heat source equipped in the substrate stage PST, the heat source equipped in the substrate stage PST is not limited to the actuators. Other examples of the heat source include an optical measuring instrument mounted at a prescribed position on the substrate stage PST for carrying out various exposure-related measurements, and the like.

Furthermore, the heat sources that change the temperature of the liquid LQ in the light path space K1 are not limited to the one in the substrate stage PST but may include, e.g., the thermal energy of the exposure light EL. That is to say, there is a possibility that, if the substrate P is irradiated by the exposure light EL, the region of the substrate P thus irradiated with the exposure light EL (namely, the region corresponding to the projection region AR) shows a change in temperature (undergoes a temperature rise). Concomitant with the temperature rise of the substrate P, a change may possibly occur in at least one of the temperature and temperature distribution of the liquid LQ making contact with the substrate P. The liquid LQ used in the present embodiment is water that absorbs some part of the ArF excimer laser light as the exposure light EL. This means that at least one of the temperature and temperature distribution of the liquid LQ in the light path space K1 may possibly be changed if the liquid LQ of the light path space K1 absorbs the thermal energy of the exposure light EL (ArF excimer laser light). Moreover, the first optical element LS 1 through which the exposure light EL passes may possibly undergo a temperature change by absorbing the thermal energy of the exposure light EL, which leads to a possibility that a change occurs in at least one of the temperature and temperature distribution of the liquid LQ in the light path space K1 making contact with the first optical element LS 1.

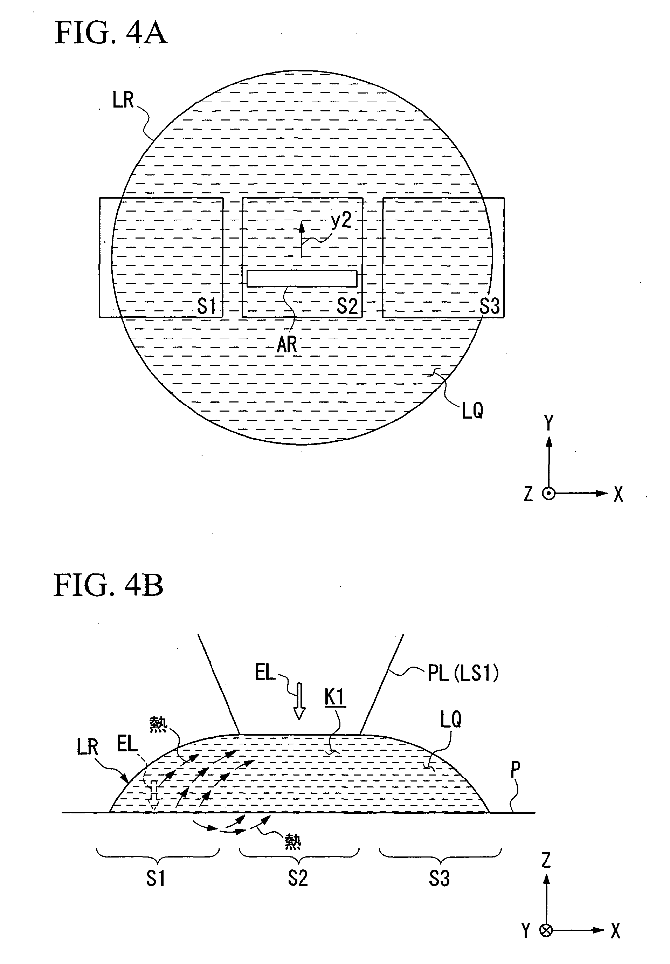

FIGS. 4A and 4B are schematic diagrams illustrating a state that the second shot region is scan-exposed after scan-exposure of the first shot region, wherein FIG. 4A is a plan view and FIG. 4B is a side elevational view. As illustrated in FIGS. 4A and 4B, the first, second and third shot regions S1, S2 and S3 are defined to be located one after the other in mutually adjacent positions and arranged in the X-axis direction (non-scanning direction) in accordance with the present embodiment. And, the scan-exposure is performed in the order of the first shot regions S1, the second shot region S2 and the third shot region S3. In FIGS. 4A and 4B, it is highly likely that the surface of the substrate P corresponding to the previously exposed first shot region S 1 is undergoing a temperature rise by irradiation of the exposure light EL. In contrast, the surface of the substrate P corresponding to the third shot region S3, which is to be exposed after exposure of the second shot region S2, is not yet irradiated by the exposure light EL and therefore does not undergo any temperature rise caused by irradiation of the exposure light EL. In this case, the temperature of the liquid LQ in the liquid immersion region LR (light path space K1) covering the projection region AR at the time of scan-exposing the second shot region S2 may possibly be affected by the first shot region S 1 which is kept at a rising temperature due to the previous irradiation of the exposure light EL. In other words, the previously exposed first shot region S1 among the plurality of shot regions serves as a heat source that changes the temperature of the liquid LQ in the light path space K1 while the second shot region S2 is subsequently being exposed. Thus, there is a possibility that at least one of the temperature and temperature distribution of the liquid LQ filled in the light path space K1 is changed under the influence of the first shot region S 1.

Referring again to FIGS. 2, 4A and 4B, at least one of the temperature and temperature distribution of the liquid LQ in the light path space K1 at the time of scan-exposing the second shot region is likely to be significantly affected by the heat from the first shot region S1 which is exposed right before and adjoins the second shot region S2 in the X-axis direction. On the other hand, at least one of the temperature and temperature distribution of the liquid LQ in the light path space K1 at the time of scan-exposing, e.g., the fifth shot region S5, may possibly be affected by the heat of the just previously exposed fourth shot region S4, but much less significantly. In other words, since the distance between the fifth shot region S5 and the fourth shot region S4 is greater than the distance between the second shot region S2 and the first shot region S 1, the thermal influence on the liquid LQ of the light path space K1 exercised by the fourth shot region S4 during the process of exposing the fifth shot region S5 is probably less than the thermal influence on the liquid LQ of the light path space K1 exercised by the first shot region S 1 during the process of exposing the second shot region S2.

As set forth above, there is a possibility that at least one of the temperature and temperature distribution of the liquid LQ in the light path space K1 is changed depending on the positional relationship between the previously exposed shot region among the plurality of the shot regions and the liquid LQ filled in the light path space K1 at the image plane side of the projection optical system PL facing the subsequently exposed shot region, namely the positional relationship between the previously exposed shot region among the plurality of the shot regions and the projection optical system PL facing the subsequently exposed shot region. More specifically, it is likely that at least one of the temperature and temperature distribution of the liquid LQ in the light path space K1 is changed depending on the distance between the previously exposed shot region and the projection optical system PL facing the subsequently exposed shot region.

Furthermore, there is a possibility that at least one of the temperature and temperature distribution of the liquid LQ in the light path space K1 is changed in accordance with the exposure order while the plurality of shot regions are exposed. As already described with reference to FIG 2, in case the first to thirty second shot regions S1-S32 are exposed in sequence, the previously exposed first shot region S1 and the subsequently exposed second shot region S2, for example, are in a mutually adjoining positional relationship. Therefore, there is a possibility that the liquid LQ in the light path space K1 is significantly affected by the heat of the just previously exposed first shot region S1 while the next second shot region S2 is exposed. On the other hand, in case a shot region distant from the first shot region S1, e.g., the twenty seventh shot region S27, is exposed after exposure of the first shot region S1, the liquid LQ in the light path space K1 at the time of exposing the twenty seventh shot region S27 has a reduced likelihood of being severely affected by the heat of the just previously exposed first shot region S1. This is because the first shot region S 1 and the twenty seventh shot region S27 are separated far away from each other.

As noted above, the thermal influence on the liquid LQ of the light path space K1 exercised by the just previously exposed first shot region during the time of the process of exposing the second shot region can be made smaller in an instance where the exposure order is determined not to consecutively expose the first shot region and the second shot region adjacent to the first shot region than in an instance where the exposure order is determined to consecutively expose the first shot region and the second shot region adjacent to the first shot region.

Furthermore, the thermal influence on the liquid LQ of the light path space K1 exercised by the just previously exposed first shot region during the time of the process of exposing the second shot region can be made smaller in an instance where the second shot region is exposed after the lapse of a second specified time interval since the exposure of the first shot region than in an instance where the second shot region is exposed after the lapse of a first specified time interval since the exposure of the first shot region, wherein the second specified time interval is longer than the first specified time interval. That is to say, if the waiting time from exposure of the first shot region to exposure of the second shot region is set longer, it is possible to expose the next second shot region in a state that the heat of the first shot region is reduced (dissipated) in proportion to the waiting time. Therefore, the liquid LQ in the light path space K1 during the time of the course of exposing the second shot region has a reduced likelihood of being heavily affected by the heat of the first shot region.

In this regard, the time interval between exposure of the first shot region and subsequent exposure of the second shot region varies with the stepping speed at the time when the projection optical system PL and the substrate P are moved relative to each other in order to expose the next second shot region after exposure of the first shot region. In other words, the time interval between exposure of the first shot region and subsequent exposure of the second shot region is prolonged by reducing the stepping speed. To the contrary, the time interval between exposure of the first shot region and subsequent exposure of the second shot region is shortened by increasing the stepping speed.

In addition, at least one of the temperature and temperature distribution of the liquid LQ in the light path space K1 also varies with the number of shot regions exposed per unit time. For example, exposure of a large number of shot regions per unit time entails an increased scanning speed and a shortened time interval between exposure of the first shot region and subsequent exposure of the second shot region (or an increased stepping speed). In this case, the liquid LQ in the light path space K1 during the course of exposing the second shot region is apt to be heavily affected by the heat of the previously exposed first shot region S 1 that has been generated by irradiation of the exposure light EL.

On the other hand, exposure of a small number of shot regions per unit time entails a reduced scanning speed and a prolonged time interval between exposure of the first shot region and subsequent exposure of the second shot region (or a reduced stepping speed). In this case, the liquid LQ in the light path space K1 during the time of exposing the second shot region is less likely to be heavily affected by the heat from the previously exposed first shot region S 1 that has been generated by irradiation of the exposure light EL.

As noted above, at least one of the temperature and temperature distribution of the liquid LQ in the light path space K1 is also changed depending on the number of shot regions exposed per unit time, which in turn is dependent upon the scanning speed at the time when the scan-exposure is performed by relatively moving the respective shot regions and the projection optical system PL and the time interval between exposure of the first shot region and subsequent exposure of the second shot region (including the stepping speed).

Moreover, there is a possibility that at least one of the temperature and temperature distribution of the liquid LQ in the light path space K1 during the time of exposing the second shot region also varies with the exposure amount (an illuminance multiplied by a time interval or an illuminance multiplied by a pulse number). In other words, if the exposure amount is increased, the exposure light EL with an increased thermal energy is irradiated on the first shot region, thereby increasing the temperature rise of the first shot region. Accordingly, the subsequently exposed second shot region is apt to be affected by the heat of the previously exposed first shot region that has been generated by irradiation of the exposure light EL.

As set forth above, there is a possibility that at least one of the temperature and temperature distribution of the liquid LQ in the light path space K1 is changed in accordance with the moving conditions of the substrate P (substrate stage PST) relative to the projection optical system PL, including the positional relationship between the projection optical system PL and the substrate P (substrate stage PST), the moving direction of the substrate P (substrate stage PST) with respect to the projection optical system PL, and the moving speed of the substrate P (substrate stage PST) relative to the projection optical system PL. Furthermore, there is a possibility that at least one of the temperature and temperature distribution of the liquid LQ in the light path space K1 is changed depending on the moving conditions of the substrate P (substrate stage PST) relative to the projection optical system PL, including the positional relationship (distance) between the previously exposed first shot region and the projection optical system facing the subsequently exposed second shot region, the exposure order in the process of exposing a plurality of shot regions, the scanning speed and stepping speed of the substrate P (substrate stage PST), and the number of shot regions exposed per unit time. Moreover, as described above, there is also a possibility that at least one of the temperature and temperature distribution of the liquid LQ in the light path space K1 is changed in accordance with the influence of the air conditioning system 300 or the exposure intensity (the irradiation conditions of the exposure light EL).

In the event that at least one of the temperature and temperature distribution of the liquid LQ in the light path space K1 has been changed in accordance with the moving conditions of the substrate P relative to the projection optical system PL or other conditions, there is a possibility that the projection state of a pattern image undergoes a change at the time of projecting the pattern image on the substrate P through the liquid LQ, thus making it impossible to obtain a desired projection state. In other words, an aberration may possibly be caused (changed) if at least one of the temperature and temperature distribution of the liquid LQ in the light path space K1 is changed in accordance with the moving conditions of the substrate P relative to the projection optical system PL or other conditions.

Thus, in the present embodiment, the exposure conditions are determined in accordance with the moving conditions of the substrate P (substrate stage PST) relative to the projection optical system PL so that the pattern image can be projected on the substrate P in a desired projection state. Then, the substrate P is exposed under the exposure conditions thus determined. In other words, a correction value (correction information) is determined for correcting an aberration attributable to the temperature variation (temperature distribution variation) of the liquid LQ caused in accordance with the moving conditions of the substrate P (substrate stage PST) relative to the projection optical system PL. The substrate P is exposed while the exposure conditions being corrected based on the correction value (correction information) thus determined.

### <Exposure Method>

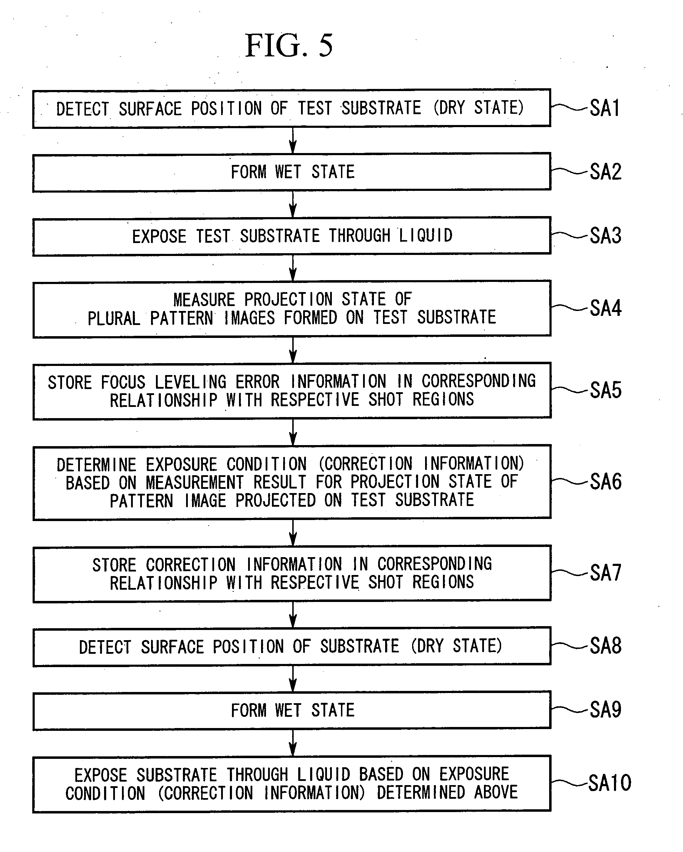

Next, an embodiment of an exposure method will be described with reference to the flowchart of FIG. 5. In the present embodiment, description will be made on an instance where the exposure conditions (correction information) for projecting the pattern image in a desired projection state are determined by use of a test substrate Pt, prior to exposing the substrate P for the manufacture of a device.

In case at least one of the temperature and temperature distribution of the liquid LQ in the light path space K1 has been changed, various aberrations such as a spherical aberration and the like are likely to occur. For the sake of simplicity, however, the following description will be made on an exemplary case that the aberration is a Z-axis variation in the position of an image plane formed through the projection optical system PL and the liquid LQ. And, description will be provided on an instance where the positional relationship between the surface of the substrate P and the image plane formed through the projection optical system PL and the liquid LQ is corrected.

Furthermore, in the following description, the state in which the liquid LQ is not filled in the light path space K1 will be arbitrarily referred to as a "dry state", and the state in which the liquid LQ is filled in the light path space K1 will be arbitrarily referred to as a "wet state". In addition, the image plane formed through the projection optical system PL and the liquid LQ will be arbitrarily referred to as a "wet-formed image plane".

In this connection, the temperature of the liquid LQ supplied from the liquid supply mechanism 10 shows little change, and the temperature variation in the liquid LQ caused by the liquid supply mechanism 10 is a negligibly low level to become a factor of the aberration. Thus, in the following description, it is assumed that the temperature of the liquid LQ supplied from the liquid supply mechanism 10 is constant.

First of all, the control unit CONT conveys (loads) the test substrate Pt onto the substrate stage PST. At this time, the mask M having a pattern for the manufacture of devices remains loaded onto the mask stage MST. And, the test substrate Pt is the same one as the substrate P that will be exposed for the manufacture of devices.

With no liquid LQ filled between the projection optical system PL and the test substrate Pt (in a dry state), the control unit CONT detects the surface position (surface information) of the test substrate Pt by use of the focus leveling detection system 30 (step SA1).

In the present embodiment, the focus leveling detection system 30 is adapted to detect the surface position (surface information) of the test substrate Pt by detecting a deviation relative to the imaging plane formed through the liquid LQ and the projection optical system PL, on the assumption that the temperature and temperature distribution of the liquid LQ is in a prescribed reference state.

More specifically, the control unit CONT detects the surface positions of a plurality of regions on the test substrate Pt by use of the focus leveling detection system 30, while monitoring the XY direction position of the substrate stage PST (test substrate Pt) with the laser interferometer 94 and moving the substrate stage PST in the XY directions. Just like the substrate P for the manufacture of devices, a plurality of shot regions S1-S32 is defined on the test substrate Pt in a matrix shape. The control unit CONT detects the surface positions of the respective shot regions S1-S32 on the test substrate Pt by use of the focus leveling detection system 30. In other words, the control unit CONT detects the surface positions in respect of a plurality of XY direction positions (coordinates) on the test substrate Pt by use of the focus leveling detection system 30. The control unit CONT allows the storage unit MRY to store, in a corresponding relationship with the measurement result from the laser interferometer 94, the information on the surface positions for the respective shot regions S 1-S32 of the test substrate Pt detected by the focus leveling detection system 30. This ensures that the information on the surface positions for the respective shot regions S1-S32 on the test substrate Pt is stored in the storage unit MRY in a corresponding relationship with the XY direction coordinate position of the test substrate Pt.

Next, the control unit CONT allows the liquid supply mechanism 10 and the liquid recovery mechanism 20 to supply and recover the liquid LQ in a state that the projection optical system PL and the upper surface 97 of the substrate stage PST are faced with each other, thereby filling the liquid LQ into the space formed between the projection optical system PL and the upper surface 97 of the substrate stage PST to form a wet state (step SA2).

Next, while allowing the liquid supply mechanism 10 and the liquid recovery mechanism 20 to supply and recover the liquid LQ, respectively, the control unit CONT makes the substrate stage PST move in the XY directions and makes the liquid immersion region LR formed at the image plane side of the projection optical system PL move onto the test substrate Pt. Since the upper surface 97 of the substrate stage PST and the surface of the test substrate Pt are substantially of the same height (flush with each other), it is possible to displace the liquid immersion region LR by moving the substrate stage PST in the XY directions in a state that the liquid LQ is held at the image plane side of the projection optical system PL.

Next, in a state that the light path space K1 between the projection optical system PL and the test substrate Pt is filled with the liquid LQ (in a wet state), the control unit CONT projects the pattern image of the mask M held in the mask stage MST on the test substrate Pt through the projection optical system PL and the liquid LQ, while moving the test substrate Pt (substrate stage PST) under prescribed moving conditions, i.e., under the same conditions as used in exposing the substrate P for the manufacture of devices (including the air-conditioning condition of the air conditioning system 300, the irradiation condition of the exposure light EL and the like). This ensures that the pattern image of the mask M is projected on each of the plurality of shot regions S1-S32 of the test substrate Pt (step SA3).

At the time of exposing the respective shot regions S1-S32 of the test substrate Pt, the control unit CONT is adapted to scan-expose the respective shot regions S1-S32 while adjusting the positional relationship between the wet-formed image plane and the surface of the test substrate Pt based on the information regarding the positional relationship between the wet-formed image plane and the surface of the test substrate Pt acquired in step SA1 but without having to use the focus leveling detection system 30. During the time of the process of adjusting the positional relationship between the wet-formed image plane and the surface of the test substrate Pt, the control unit CONT adjusts the Z-axis direction position and the θX and θY direction positions of the test substrate Pt by, e.g., controlling the movement of the substrate stage PST for holding the test substrate Pt in place.

In this regard, if the temperature and temperature distribution of the liquid LQ in the light path space K1 are not changed in accordance with the moving conditions of the substrate stage PST (test substrate Pt) relative to the projection optical system PL, it would be possible to bring the wet-formed image plane and the surface of the test substrate Pt into coincidence with each other at the time of exposing the respective shot regions S1-S32 of the test substrate Pt. As mentioned earlier, however, there is a possibility that at least one of the temperature and temperature distribution of the liquid LQ filled in the light path space K1 is changed depending on the moving conditions of the substrate stage PST (test substrate Pt) relative to the projection optical system PL, thereby changing the positional relationship between the surface of each of the shot regions S1-S32 of the test substrate Pt and the wet-formed image plane.

After the pattern image of the mask M has been projected on the respective shot regions S1-S32 of the test substrate Pt, the control unit CONT unloads the test substrate Pt from the substrate stage PST. Subsequently, the shape (line width) of the patterns formed on the respective shot regions S1-S32 of the test substrate Pt is measured with a shape measuring instrument (step SA4).

The shape measuring instrument includes, e.g., a scan-type electronic microscope (SEM), and is capable of measuring the shape (line width) of the patterns formed on the respective shot regions S1-S32 of the test substrate Pt. As the shape measuring instrument, it may be possible to use other types of measuring instruments such as an electric resistance type measuring instrument and the like.

By measuring the shape (line width) of the test patterns with the shape measuring instrument, it becomes possible to measure the projection state of the pattern image at the time of exposing the respective shot regions S1-S32 of the test substrate Pt.

If the positional relationship between the wet-formed image plane and the surface of the test substrate Pt is optimized, the image projected on the test substrate Pt exhibits a highest contrast and the line width of the patterns formed on the test substrate Pt comes into a desired state. On the other hand, if the positions of the wet-formed image plane and the surface of the test substrate Pt are deviated from each other, the line width of the patterns formed on the test substrate Pt grows thinner or thicker. That is to say, the line width of the patterns formed on the test substrate Pt varies with the positional relationship between the wet-formed image plane and the surface of the test substrate Pt. Therefore, based on the measurement result from the shape measuring instrument, the control unit CONT can find the deviation amount (the information on a focus leveling error) between the image plane wet-formed in a given moving condition and the surface of the test substrate Pt in respect of the respective shot regions S1-532.

The control unit CONT allows the storage unit MRY to store, in a corresponding relationship with the respective shot regions S1-S32, the information on the focus leveling error attributable to the temperature variation (temperature distribution variation) in the liquid LQ in the light path space K1 caused due to the moving conditions of the test substrate Pt relative to the projection optical system PL (step SA5).

Through the process described above, the projection state of the pattern image projected on the test substrate Pt under the moving conditions available at the time of exposure of the substrate P are measured prior to exposing the substrate P for the manufacture of devices. The measurement result from the shape measuring instrument is outputted to the control unit CONT.

Based on the measurement result from the shape measuring instrument, the control unit CONT determines the exposure conditions assuring to have a projection of the pattern image in a desired projection state, in respect of the respective shot regions S1-S32, i.e., a plurality of XY direction positions(coordinates) on the substrate P (step SA6).

In the present embodiment, respective correction values (correction information) regarding the Z-axis, θX and θY direction movements of the substrate stage PST are found in a corresponding relationship with the plurality of XY direction positions (coordinates) on the substrate P, so that the positional relationship between the wet-formed image plane in a given moving condition and the surface of the test substrate Pt can be in a desired state, namely so that the wet-formed image plane in a given moving condition and the surface of the test substrate Pt can coincide with each other. In other words, the control unit CONT associates the correction values (correction information) regarding the Z-axis, θX and θY direction movements of the substrate stage PST with the plurality of XY direction positions (coordinates) on the substrate P to obtain the values.

In this regard, the relationship between the pattern shape (line width), the positional relationship between the wet-formed image plane and the surface of the test substrate Pt, and the correction value regarding the movement of the substrate stage PST is found in advance by virtue of, e.g., an experiment or a simulation, and is stored in the storage unit MRY Based on the measurement result from the shape measuring instrument and the information stored in the storage unit MRY, the control unit CONT can find, in a corresponding relationship with the respective shot regions S1-S32, the correction value regarding the movement of the substrate stage PST required to keep the positional relationship between the wet-formed image plane and the surface of the test substrate Pt in a desired state.

In a corresponding relationship with the respective shot regions S1-S32, the control unit CONT determines the correction value (correction information) regarding the movement of the substrate stage PST required to correct the focus leveling error attributable to the temperature variation (temperature distribution variation) in the liquid LQ in the light path space K1 caused due to the moving conditions of the test substrate Pt relative to the projection optical system PL. The correction value (correction information) thus determined is stored in the storage unit MRY in a corresponding relationship with the respective shot regions S1-S32 (step SA7).

By doing so, the exposure conditions (correction information) required to ensure that the pattern image is projected on the substrate P in a desired projection state in accordance with the moving conditions of the substrate P relative to the projection optical system PL are stored in the storage unit MRY.

Next, the control unit CONT conveys (loads) the substrate P for the manufacture of devices onto the substrate stage PST. Then, in a state that the liquid LQ is not filled into the space formed between the projection optical system PL and the substrate P (in a dry state), the control unit CONT detects the surface position (surface information) of the substrate P by use of the focus leveling detection system 30 (step SA8).

More specifically, as with the test substrate Pt, the control unit CONT detects the surface positions of a plurality of regions on the substrate P by use of the focus leveling detection system 30, while monitoring the XY direction position of the substrate stage PST (substrate P) with the laser interferometer 94 and moving the substrate stage PST in the XY directions. The control unit CONT detects the surface positions of the respective shot regions S1-S32 on the substrate P by use of the focus leveling detection system 30. The control unit CONT allows the storage unit MRY to store, in a corresponding relationship with the measurement result from the laser interferometer 94, the information on the surface positions of the respective shot regions S 1-S32 of the substrate P detected by the focus leveling detection system 30. This ensures that the information on the surface positions of the respective shot regions S1-S32 of the substrate P is stored in the storage unit MRY in a corresponding relationship with the XY direction coordinate position of the substrate P relative to a prescribed reference position (e.g., the projection optical system PL).

Subsequently, the control unit CONT allows the projection optical system PL and the upper surface 97 of the substrate stage PST to face with each other and then creates a wet state by filling the liquid LQ into the space formed between the projection optical system PL and the upper surface 97 of the substrate stage PST (step SA9).

Next, while allowing the liquid supply mechanism 10 and the liquid recovery mechanism 20 to supply and recover the liquid LQ, respectively, the control unit CONT makes the substrate stage PST move in the XY directions and makes the liquid immersion region LR formed on the image plane side of the projection optical system PL move onto the substrate P.

Next, in a state that the light path space K1 between the projection optical system PL and the substrate P is filled with the liquid LQ (in a wet state), the control unit CONT projects the pattern image of the mask M held in the mask stage MST on the substrate P through the projection optical system PL and the liquid LQ, while moving the substrate P (substrate stage PST) under the same prescribed moving conditions as used in exposing the test substrate Pt (including the air-conditioning condition of the air conditioning system 300, the irradiation condition of the exposure light EL and the like). This ensures that the pattern image of the mask M is projected on each of the plurality of shot regions S1-S32 of the substrate P.

At the time of exposing the respective shot regions S1-S32 on the substrate P, the control unit CONT determines the exposure conditions required to expose the respective shot regions S1-S32, i.e., the displacement amount of the substrate stage PST required to bring the wet-formed image plane and the surfaces of the respective shot regions S1-S32 of the substrate P into coincidence with each other, based on the information regarding the positional relationship between the wet-formed image plane and the surface of the substrate P, which was found in step SA8, and the correction value (correction information) required to correct the error attributable to the temperature variation (temperature distribution variation) in the liquid LQ in the light path space K1 caused due to the moving conditions of the substrate P relative to the projection optical system PL, which was stored in step SA7. And, based on the displacement amount thus determined, the control unit CONT displaces the substrate stage PST holding the substrate P and performs exposure. At the time of exposing the substrate P, the control unit CONT is adapted to scan-expose the respective shot regions S1-S32, while adjusting the Z-axis direction position and the θX and θY direction positions of the substrate stage PST holding the substrate P and hence adjusting the positional relationship between the wet-formed image plane and the surface of the substrate P but without having to use the focus leveling detection system 30 (step SA10).

In this way, based on the storage information of the storage unit MRY pre-storing the exposure conditions required to assure projection of the pattern image on the respective shot regions S1-S32 on the substrate P in a desired projection state, the exposure conditions (correction value) are determined in accordance with the moving conditions of the substrate P relative to the projection optical system PL. The substrate P is exposed under the exposure conditions thus determined.

Although, for the purpose of simplicity, the above description has been made on an exemplary case that the wet-formed image plane is moved in the Z-axis direction in accordance with the moving conditions of the substrate P, consideration is also given to the inclination (deviations in the θX and θY directions) of the image plane. Particularly, at the time of exposing, e.g., the second shot region S2 as set forth above with reference to FIGS. 4A and 4B, there is a possibility that the wet-formed image plane is inclined in the θY direction if the first shot region S1 at the -X side of the second shot region S2 has a high temperature and the third shot region S3 at the +X side of the second shot region S2 has a low temperature. In such a case, patterns corresponding to the inclination of the image plane are formed on the test substrate Pt. Therefore, at the time when the patterns are measured with the shape measuring instrument and the second shot region S2 on the substrate P is exposed based on the measurement result, it is desirable to determine a correction value regarding the movement of the substrate stage PST (a tilting amount in the θY direction) so that the wet-formed image plane and the surface of the second shot region S2 can be brought into coincidence with each other. Furthermore, in case the image plane is inclined in the θX direction, it is desirable to determine a correction value regarding the movement of the substrate stage PST (a tilting amount in the θX direction) so that the wet-formed image plane and the surface of the second shot region S2 can be made to be coincident with each other.

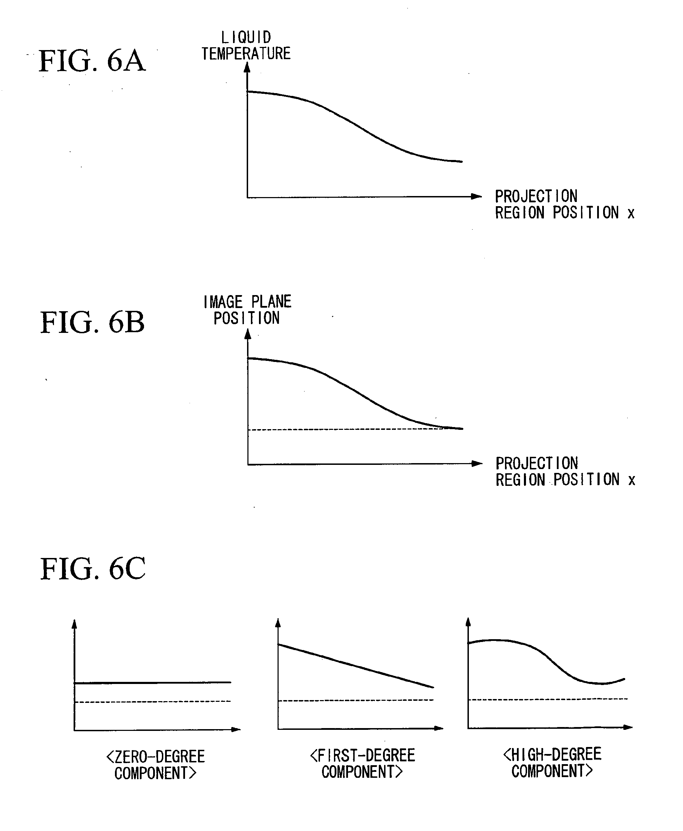

Moreover, in the event that a nonlinear X-axis temperature distribution is generated in the liquid LQ of the light path space K1 as illustrated in FIG. 6A, the image plane formed through the projection optical system PL and the liquid LQ has a profile corresponding to the nonlinear temperature distribution as depicted in FIG. 6B. Taking this into account, the control unit CONT divides a position variation component of the image plane (an imaging characteristic variation component) into a plurality of components, i.e., a zero-order component, a first-order inclination component and a high-order component as illustrated in FIG 6C. The control unit CONT determines the correction values (exposure conditions) for the respective components and performs the exposure while making correction based on the correction values thus determined. For example, with respect to the zero-order and first-order image plane variation components, it is possible to correct the positional relationship between the wet-formed image plane and the surface of the substrate P by way of correcting the position (posture) of the substrate stage PST in the same manner as described above. On the other hand, with regard to the high-order component, the correction can be made by operating the imaging characteristic adjustment unit LC and then adjusting the imaging characteristics of the projection optical system PL at the time when the pattern image is projected on the substrate P. In case the low order aberrations are corrected, it may of course be possible to use the imaging characteristic adjustment unit LC or to perform the position (posture) adjustment of the substrate stage PST in combination with the adjustment made by the imaging characteristic adjustment unit LC.

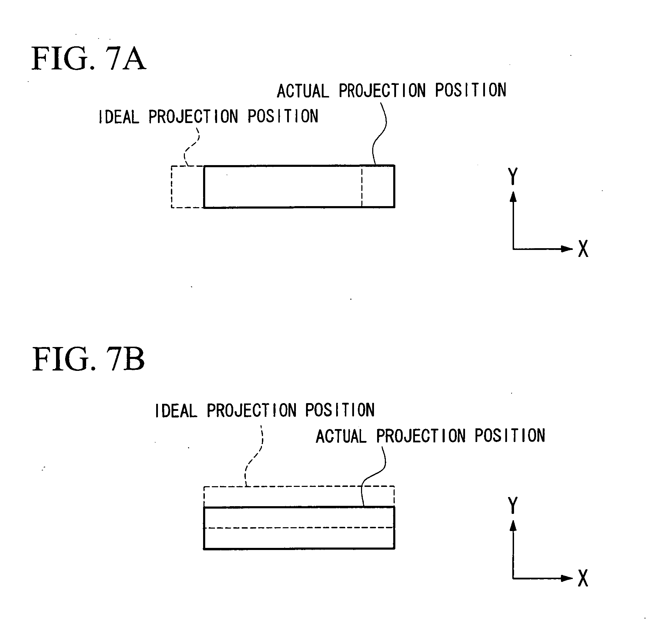

In addition, depending on the temperature distribution of the liquid LQ filled in the light path space K1, the actual projection position may possibly be shifted in the X-axis direction relative to the ideal projection position (target projection position) as illustrated in the schematic diagram of FIG. 7A or shifted in the Y-axis direction relative to the ideal projection position (target projection position) as shown in the schematic diagram of FIG. 7B. Such an aberration can also be measured by use of the test substrate Pt and the shape measuring instrument. In this case, based on the measurement result from the shape measuring instrument, the control unit CONT corrects the position of the substrate stage PST at the time of exposing the substrate P so that the actual projection position can coincide with the target projection position on the substrate P. Furthermore, in this case, it may be possible to make the actual projection position coincide with the target projection position on the substrate P by use of the imaging characteristic adjustment unit LC or to perform the position adjustment of the substrate stage PST in combination with the adjustment made by the imaging characteristic adjustment unit LC.

Moreover, although the above-noted low-order aberrations (a Z-axis direction deviation, an XY direction deviation, θX and θY direction deviations of the image plane, and the like) can be found by measuring the pattern shape formed on the test substrate Pt with the shape measuring instrument and using the result of measurement, it may be possible, as disclosed in, e.g., Japanese Patent Application, Publication No. 2002-139406, to measure a wavefront aberration of a liquid immersion type projection optical system PL including a projection optical system PL and a liquid LQ, by projecting an image of prescribed measurement pattern on a measuring substrate through the projection optical system PL and the liquid LQ and fitting the positional information (position deviation information) of the measurement pattern formed on the measuring substrate to the Zernike polynomial (a cylindrical function system). In this case, based on the measurement result, the imaging characteristics of the projection optical system PL at the time of projecting the pattern image on the substrate P may be determined by means of the imaging characteristic adjustment unit LC so as to assure a desired projection state.

As described above, by determining the exposure conditions in accordance with the moving conditions of the substrate P (substrate stage PST) relative to the projection optical system PL, it becomes possible to project the pattern image on the substrate P in a desired projection state and then perform exposure.

In general, a liquid has a larger absorption coefficient than a gas and is apt to easily undergo a temperature change. Furthermore, the temperature dependency of a refractive index change of a liquid with respect to the exposure light EL is far greater than the temperature dependency of a refractive index change of a gas. As an example, it is known that, in case the temperature is changed by 1 °C, the refractive index variation in pure water becomes 120 times as great as the refractive index variation in the air. Moreover, the temperature dependency of a refractive index change of a liquid is greater than the temperature dependency of a refractive index change of the first optical element LS1 made of silica glass or the like. In other words, even if the temperature variation (temperature rise amount) in the liquid LQ filled in the light path space K1 is very small, the refractive index of the liquid LQ with respect to the exposure light EL undergoes a significant change. Thus, for the purpose of obtaining a desired projection state, it is important to fully suppress the temperature change or the temperature distribution change in the liquid LQ in the light path space K1.

However, depending on the moving conditions of the substrate P (substrate stage PST) relative to the projection optical system PL, it may be the case that the liquid LQ in the light path space K1 undergoes a temperature change or a temperature distribution change, thereby making it difficult to project a desired pattern image.

In the present embodiment, a certain degree of change in the temperature or temperature distribution in the liquid LQ in the light path space K1 in accordance with the moving conditions of the substrate P (substrate stage PST) relative to the projection optical system PL is permissible. The pattern image can be projected on the substrate P in a desired projection state, by way of adjusting the positional relationship between the substrate P and the image plane formed through the projection optical system PL and the liquid LQ with the use of the substrate stage PST or adjusting the imaging characteristics of the projection optical system PL at the time of projecting the pattern image on the substrate P with the use of the imaging characteristic adjustment unit LC, in accordance with the moving conditions of the substrate P (substrate stage PST) relative to the projection optical system PL.

In an effort to suppress the temperature change or the temperature distribution change in the liquid LQ, it may be possible to adjust the temperature of the liquid LQ supplied from the supply ports 12 of the nozzle member 70 or the temperature distribution in the liquid LQ supplied from the supply ports 12 in accordance with the moving conditions of the substrate P (substrate stage PST).

Furthermore, in the embodiments described above, the surface information of the substrate P is detected in a dry state by use of the focus leveling detection system 30 prior to exposing the substrate P, and the surface information of the substrate P detected in the dry state is correlated with the image plane formed in the wet state. Alternatively, it may be possible to detect the surface information of the substrate P in the wet state by use of the focus leveling detection system 30. At the time of exposing the substrate P, the control unit CONT is adapted to operate the substrate stage PST (and/or the imaging characteristic adjustment unit LC) based on the wet-state detection results of the surface of the substrate P.

Moreover, in the embodiments described above, use is made of the focus leveling detection system 30 that has a detection point within the projection region AR of the projection optical system PL or in the vicinity thereof. In place of the focus leveling detection system with such a detection point, it may be possible to use a focus leveling detection system having a detection point in a position distant from the projection region AR, e.g., in an exchange position of the substrate P.

In addition, in the embodiments described above, the substrate stage PST or the imaging characteristic adjustment unit LC is operated to adjust the projection state. Alternatively, it may be possible to operate the mask stage MST holding the mask M for that purpose. In case of operating the mask stage MST, it may be possible to operate the mask stage MST either independently or in combination with at least one of the substrate stage PST and the imaging characteristic adjustment unit LC.

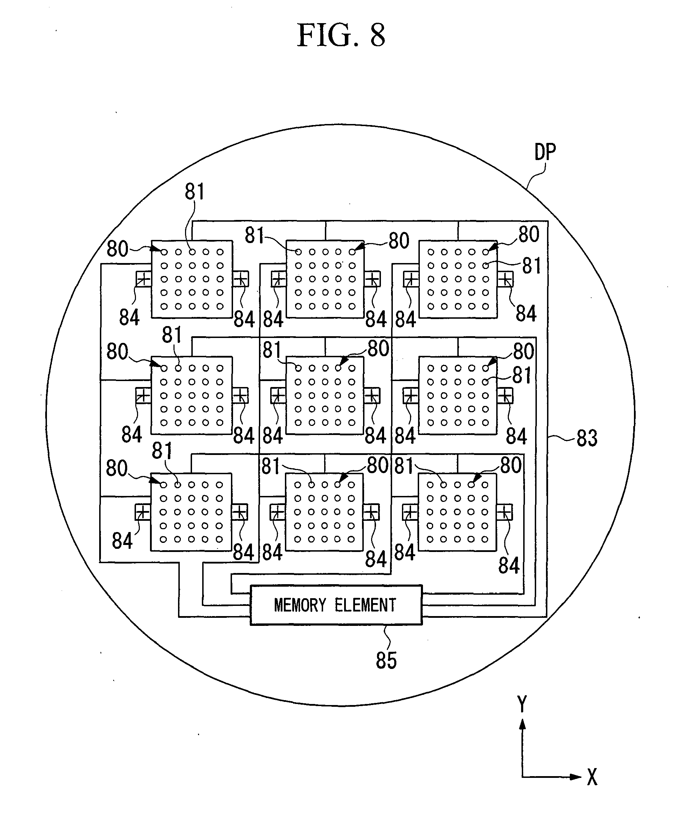

Furthermore, in the embodiments described above, the correction value is found by measuring the shape of the pattern formed on the test substrate Pt. However, in the event that the correlation between the temperature (temperature distribution) of the liquid LQ and the aberration (e.g., the variation in the image plane position) is found in advance, it is possible to perform an exposure operation for a dummy substrate DP by use of, e.g., temperature sensors 80 provided on the dummy substrate DP as illustrated in FIG. 8, in the same exposure method as applied to the test substrate Pt, measure the temperature of the liquid LQ in the light path space K1 at the time of exposing the respective shot regions S1-S32, find an aberration variation occurring in the respective shot regions S1-S32 based on the measurement result from the temperature sensors 80 and the above-noted correlation, and determine the exposure conditions (correction value) required to correct the aberration variation.

Referring to FIG 8, the dummy substrate DP has substantially the same size and shape as those of the substrate P for the manufacture of devices and is capable of being held on the substrate stage PST that has an ability to hold and move the substrate P. And, the temperature sensors 80 are provided in plural numbers on the surface of the dummy substrate DP. Each of the temperature sensors 80 has a plurality of sensor elements 81 provided on the surface of the dummy substrate DP. Each of the sensor elements 81 includes, for example, a thermocouple. A plurality of sensor arrangement regions SC corresponding to the shot regions S1-S32 is defined on the dummy substrate DP, and the sensor elements 81 are arranged on the respective sensor arrangement regions SC in plural numbers and in a matrix shape when seen from the top. In the present embodiment, the number of the sensor elements 81 provided in one of the sensor arrangement regions SC is twenty five (25) in total, five in the X-axis direction and five in the Y-axis direction (5x5). Although nine sensor arrangement regions SC are illustrated in FIG 8 for the sake of easier understanding, it is true in practice that thirty two (32) sensor arrangement regions SC corresponding in number to the shot regions S1-S32 are arranged in a matrix shape.

Each of the sensor elements 81 of the temperature sensor 80 has a measuring portion (probe) exposed above the dummy substrate DP for measurement of the temperature of the liquid LQ in the light path space K1. By allowing the substrate stage PST to hold the dummy substrate DP having the temperature sensors 80, it becomes possible to measure the temperature of the liquid LQ in the light path space K1. Furthermore, provision of the sensor elements 81 in plural numbers makes it possible to measure the temperature distribution in the liquid LQ. Additionally, a memory element 85 for storing temperature measurement signals from the temperature sensors 80 is provided on the dummy substrate DP. The memory element 85 and the sensor elements 81 (temperature sensors 80) are connected to each other by way of transmission lines (cables) 83, and the temperature measurement signals from the sensor elements 81 (temperature sensors 80) are sent to the memory element 85 through the transmission lines (cables) 83. The control unit CONT is capable of extracting (reading out) the temperature measurement result stored in the memory element 85.

In the respective sensor arrangement regions SC on the dummy substrate DP, there are provided alignment marks 84 used in aligning the sensor arrangement regions SC with given positions. The alignment marks 84 are detected by means of an alignment system not shown in the drawings. At the time of loading the dummy substrate DP onto the substrate stage PST, the alignment system finds the positional information of the projection region AR of the projection optical system PL relative to the temperature sensors 80 (sensor elements 81) arranged in the sensor arrangement regions SC, based on the position detection results for the alignment marks 84. Subsequently, the sensor elements 81 in the respective sensor arrangement regions SC and the projection region AR of the projection optical system PL are position-aligned by use of the alignment marks 84.

The control unit CONT can measure the temperature (temperature distribution) of the liquid LQ by moving the substrate stage PST at the image plane side of the projection optical system PL in a state that the dummy substrate DP shown in FIG. 8 is held on the substrate stage PST and the liquid LQ is filled into the space formed between the dummy substrate DP and the projection optical system PL. Furthermore, by way of measuring the temperature (temperature distribution) of the liquid LQ with the dummy substrate DP in a non-radiation state of the exposure light EL, it is possible for the control unit CONT to find the temperature information (temperature distribution information) of the liquid LQ in the non-radiation state of the exposure light EL in accordance with the moving conditions of the substrate stage PST relative to the projection optical system PL. Measurement of the temperature of the liquid LQ in the non-radiation state of the exposure light EL makes it possible to find the influence on the liquid LQ exercised by other heat sources than the exposure light EL, particularly including the heat generation from the heat source (actuators) in the substrate stage PST and the air conditioning conducted by the air conditioning system 300. And, based on the results thus found, it is possible to determine the correction value regarding, e.g., the movement of the substrate stage PST.

Moreover, in the embodiments set forth above, the correction information is stored in the storage unit MRY in a corresponding relationship with the respective shot regions S1-S32 of the substrate P. Alternatively, the correction information used while exposing the respective shot regions may be stored in the storage unit MRY in a corresponding relationship with the scanning direction position of the mask M or the substrate P.

Furthermore, such wavefront aberration measuring devices as disclosed in, e.g., PCT International Publication No. WO 99/60361 and Japanese Patent Application, Publication Nos. 2002-71514 and 2002-334831, may be used to measure the projection state of the pattern image formed through the projection optical system PL and the liquid LQ (the information on the wavefront aberration). And, based on the measurement result, the imaging characteristics of the projection optical system PL at the time of projecting the pattern image on the substrate P may be corrected by use of, e.g., the imaging characteristic adjustment unit LC, so that a desired projection state can be obtained. In this case, it is possible to find the wavefront aberration of the liquid immersion type projection optical system, including the projection optical system PL and the liquid LQ, by fitting the measurement result from the wavefront aberration measuring devices to the Zernike polynomial (a cylindrical function system) as taught in, e.g., Japanese Patent Application, Publication No. 2002-250677. Based on the measurement result from the wavefront aberration measuring devices, the control unit CONT determines the exposure conditions (correction information) so as to assure a desired projection state.

Moreover, in the embodiments set forth above, the projection state of the pattern image is adjusted by taking into account the temperature state (the temperature, the temperature distribution and the like) of the liquid LQ that varies with the moving conditions of the substrate P. Alternatively, it may be possible to adjust the projection state of the pattern image by considering a change in the contact angle (including the dynamic contact angle) of the liquid LQ on the object surface (including the surface of the substrate P and the upper surface 97 of the substrate stage PST) on which the liquid immersion region LR is formed in accordance with the moving conditions of the substrate P. If the contact angle of the liquid LQ with respect to the object surface on which the liquid immersion region LR is formed undergoes a change, there is a possibility that the pressure of the liquid LQ forming the liquid immersion region LR is changed, thereby displacing the optical element LS 1 or deforming and displacing the substrate P. As an example, in a condition that the liquid immersion region LR is moved along the boundary between the upper surface 97 of the substrate stage PST and the surface of the substrate P, it may be possible to adjust the projection state of the pattern image (e.g., the positional relationship between the pattern image plane and the surface of the substrate P) in such a manner that the pattern image is not deteriorated by the pressure change of the liquid LQ.

As set forth above, the liquid LQ used in the present embodiment is pure water. The pure water provides an advantage that it can be easily acquired in large quantities in a semiconductor fabricating factory, and the like, and does not adversely affect a photoresist on the substrate P or an optical element (lens). Moreover, the pure water has no adverse effect on the environment and contains an extremely small amount of impurities, which comes up to an expectation that the pure water serves to cleanse the surface of the substrate P and the surface of the optical element provided on the tip end surface of the projection optical system PL. Furthermore, in case the pure water supplied from a factory, and the like, exhibits a low degree of purity, the exposure apparatus may be provided with an ultrapure water production device.

And, the pure water (typical water) is said to have a refractive index "n" of about 1.44 with respect to the exposure light EL whose wavelength is about 193nm. In case ArF excimer laser light (with a wavelength of 193nm) is used as the exposure light EL, the wavelength thereof on the substrate P is reduced to 1/n, i.e., 134nm, thus providing an increased resolution power. Furthermore, the depth of focus becomes "n" times, i.e., 1.44 times, as great as that in the air. Thus, the aperture number of the projection optical system PL can be further increased in case it is desirable to secure about the same depth of focus as is available in the air. This also helps to enhance the resolution power.

In the present embodiment, the optical element LS1 is attached to the tip end of the projection optical system PL. Optical characteristics, e.g., aberrations (a spherical aberration, a coma aberration and the like), of the projection optical system PL can be adjusted by means of this lens. Furthermore, the optical element attached to the tip end of the projection optical system PL may be either an optical plate used in adjusting the optical characteristics of the projection optical system PL or a parallel flat panel that permits transmission of the exposure light EL therethrough.

Furthermore, in the event that the flow of the liquid LQ creates a high pressure between the optical element at the tip end of the projection optical system PL and the substrate P, it may be possible to fixedly secure the optical element against any movement otherwise caused by the pressure, instead of making the optical element replaceable.

Furthermore, in the present embodiment, the liquid LQ is filled into the space formed between the projection optical system PL and the surface of the substrate P. As an alternative example, the liquid LQ may be filled in a state that a glass cover formed of a parallel flat panel is attached to the surface of the substrate P.

Moreover, with the projection optical system of the foregoing embodiments, the light path space on the image plane side of the optical element arranged at the tip end thereof is filled with the liquid. Alternatively, it may be possible to employ a projection optical system in which the light path space on the mask side of the optical element arranged at the tip end thereof is also filled with the liquid, as disclosed in PCT International Publication No. WO 2004/019128.

Furthermore, liquid other than water may be used as the liquid LQ, although the liquid LQ is water in the present embodiment. As an example, in case a source of the exposure light EL is an F₂ laser that generates F₂ laser light with no ability to penetrate water, the liquid LQ may be, e.g., fluorine-based liquid, such as perfluorinated polyether (PFPE) and fluorinated oil, permitting penetration of the F₂ laser light. In this case, the portion making contact with the liquid LQ is subjected to a hydrophilic treatment by, e.g., forming a thin film on that portion with a material of low-polarity molecular structure including fluorine. In addition to the above, it may be possible to use, as the liquid LQ, a material (e.g., cedar oil) that permits transmission of the exposure light EL, has a refractive index as high as possible and exhibits stability with respect to the projection optical system PL or a photoresist coated on the surface of the substrate P.

Moreover, as the substrate P of the respective embodiments described above, it is possible to use not only a semiconductor wafer for the manufacture of semiconductor devices but also a glass substrate for display devices, a ceramics wafer for thin film magnetic heads and a raw plate of mask or reticle (a synthetic quartz wafer or a silicon wafer) used in an exposure apparatus.

As for the exposure apparatus EX, the present invention may be applied to a step-and-repeat type projection exposure apparatus (a stepper) that collectively exposes the pattern of the mask M while the mask M and the substrate P being kept in a stopped state and sequentially moves the substrate P step by step, as well as a step-and-scan type scanning exposure apparatus (a scanning stepper) that scan-exposes the pattern of the mask M by synchronously moving the mask M and the substrate P.

Furthermore, as for the exposure apparatus EX, the present invention may be applied to an exposure apparatus of the type collectively exposing the reduced image of a first pattern on a substrate P by use of a projection optical system (e.g., a dioptric type projection optical system with a reduction ratio of 1/8 but with no reflection element) in a state that the first pattern and the substrate P are kept nearly immovable. In this case and subsequent to the above process, the present invention may be applied to a stitching exposure apparatus by which the reduced image of a second pattern is partially overlapped with the first pattern and collectively exposed on the substrate P by use of the projection optical system in a state that the second pattern and the substrate P are kept nearly immovable. Moreover, as for the stitching exposure apparatus, the present invention may be applied to a step-and-stitch type exposure apparatus by which at least two patterns are transferred to the substrate P in a partially overlapped state and the substrate P is moved step by step.

The present invention may also be applied to a twin stage type exposure apparatus provided with a plurality of substrate stages, as disclosed in Japanese Patent Application, Publication No. H10-163099, Japanese Patent Application, Publication No. H10-214783, Published Japanese Translation No. 2000-505958 of the PCT International Publication and so forth. In this case, during the course of liquid-immersing and exposing a substrate held on one substrate stage, it is possible to measure, in a dry state, the surface position (surface information) of a substrate held on the other substrate stage.

Furthermore, the present invention may be applied to an exposure apparatus that includes a substrate stage for holding a substrate and a measurement stage which carries a reference member with a reference mark and various kinds of photoelectric sensors, as disclosed in Japanese Patent Application, Publication No. H11-135400. In this case, by allowing a liquid immersion region LR on the image plane side of a projection optical system PL to move between the substrate stage and the measurement stage, it is possible to measure, in a dry state, the surface position (surface information) of the substrate held on the substrate stage in a state that the liquid immersion region LR is formed on the measurement stage.

Although the exposure apparatus employed in the foregoing embodiments is of the type locally filling the liquid into the space formed between the projection optical system PL and the substrate P, the present invention may be applied to a liquid immersion exposure apparatus for performing exposure in a state that the entire surface of an exposure target substrate is soaked in the liquid, as disclosed in Japanese Patent Application, Publication No. H06-124873, Japanese Patent Application, Publication No. H10-303114, U.S. Patent No. 5,825,043 and so forth.

As for the kind of exposure apparatus EX, the present invention is not limited to the exposure apparatus for the manufacture of semiconductor devices that exposes a semiconductor device pattern on the substrate P but may be extensively applied to an exposure apparatus for the manufacture of liquid crystal display devices or for the manufacture of displays, an exposure apparatus for the manufacture of thin film magnetic heads, image pickup devices (CCD), reticles or masks, and other exposure apparatuses.

As described above, the exposure apparatus EX in accordance with the embodiments of the present invention is manufactured by assembling various subsystems, including the respective elements recited in the claims of the subject application, so as to maintain specified mechanical, electrical and optical accuracy. In order to assure the various kinds of accuracy, calibration is conducted before and after the assembly process to accomplish optical accuracy for various optical systems, mechanical accuracy for various mechanical systems and electrical accuracy for various electric systems. The process for assembling the various subsystems into the exposure apparatus includes the tasks of mechanically interconnecting the various subsystems, connecting wire lines of an electric circuit and connecting pipelines of a pneumatic pressure circuit. It is a matter of course that individual processes for assembling each of the subsystems precede the process for assembling the various subsystems into the exposure apparatus. Once the process for assembling the various subsystems into the exposure apparatus comes to an end, general calibration is executed to assure various kinds of accuracy for the exposure apparatus as a whole. Moreover, it is desirable that the exposure apparatus be manufactured in a clean room whose temperature and degree of cleanliness are controlled.

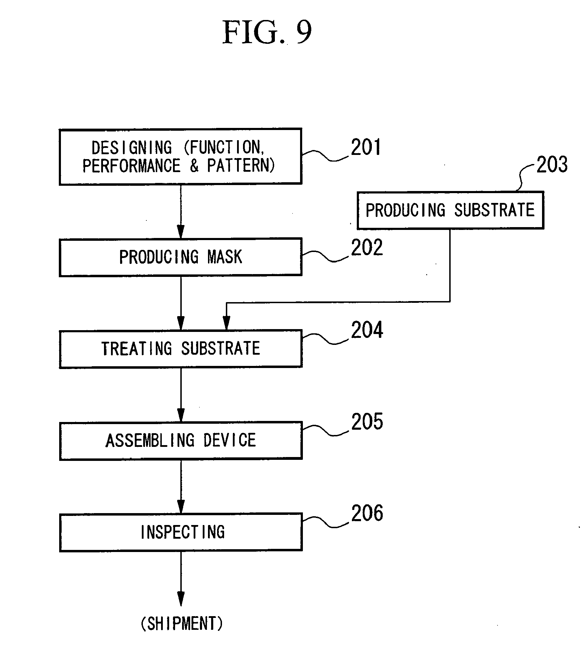

As illustrated in FIG. 9, micro devices such as semiconductor devices and the like are manufactured by way of a step 201 of designing a function, a performance and a pattern of the micro devices, a step 202 of producing a mask (reticle) based on the designing step, a step 203 of producing a substrate as a base member of the devices, a step 204 including a treatment by which a mask pattern is exposed on the substrate by means of the exposure apparatus EX of the foregoing embodiments, a step 205 of assembling the devices (including a dicing step, a bonding step and a packaging step) and an inspection step 206.

## Claims

1. An exposure method for exposing a substrate by filling liquid in a light path space formed between a projection optical system and the substrate and projecting a pattern image on the substrate through the projection optical system and the liquid, comprising:
determining an exposure condition in accordance with a moving condition of the substrate relative to the projection optical system so that the pattern image is projected on the substrate in a desired projection state; and
exposing the substrate in the determined exposure condition.

2. The exposure method according to claim 1, wherein at least one of a temperature and a temperature distribution of the liquid in the light path space varies with the moving conditions.

3. The exposure method according to claim 1 or 2, wherein the substrate is moved together with a heat source that changes the temperature of the liquid in the light path space.

4. The exposure method according to any one of claims 1 to 3, wherein the substrate is held by a movable member and moved at an image plane side of the projection optical system and wherein the moving condition comprises a moving condition of the movable member.

5. The exposure method according to claim 4, wherein the movable member has a heat source that changes the temperature of the liquid in the light path space.

6. The exposure method according to any one of claims 1 to 5, wherein the moving condition comprises a positional relationship between the projection optical system and the substrate.

7. The exposure method according to any one of claims 1 to 6, wherein the moving condition comprises a moving direction of the substrate relative to the projection optical system.

8. The exposure method according to any one of claims 1 to 7, wherein the moving condition comprises a moving speed of the substrate relative to the projection optical system.

9. The exposure method according to any one of claims 1 to 8, wherein the substrate is scan-exposed while the projection optical system and the substrate are being relatively moved from each other and wherein the moving condition comprises a scanning speed.

10. The exposure method according to any one of claims 1 to 9, wherein a plurality of shot regions are defined on the substrate and are exposed one after another.

11. The exposure method according to claim 10, wherein a previously exposed first shot region among the plurality of shot regions serves as a heat source that changes the temperature of the liquid in the light path space at the time of subsequently exposing a second shot region.

12. The exposure method according to claim 10 or 11, wherein the moving condition comprises a positional relationship between the previously exposed first shot region among the plurality of shot regions and the projection optical system facing the subsequently exposed second shot region.

13. The exposure method according to claim 12, wherein the positional relationship between the previously exposed first shot region and the projection optical system facing the subsequently exposed second shot region comprises a distance between the first shot region and the projection optical system.

14. The exposure method according to any one of claims 10 to 13, wherein the moving condition comprises an exposure order at the time of exposing the plurality of shot regions.

15. The exposure method according to any one of claims 10 to 14, wherein the moving condition comprises a stepping speed at the time of relatively moving the projection optical system and the substrate to expose the second shot region after exposing the first shot region among the plurality of shot regions.

16. The exposure method according to any one of claims 10 to 15, wherein the moving condition comprises a scanning speed at the time of scan-exposing the substrate while relatively moving each of the shot regions and the projection optical system, and the number of shot regions exposed per unit time, which depends on the time interval from exposure of the first shot region to subsequent exposure of the second shot region.

17. The exposure method according to any one of claims 1 to 16, wherein the exposure condition comprises a positional relationship between the substrate and the image plane formed through the projection optical system and the liquid.

18. The exposure method according to any one of claims 1 to 17, wherein the exposure condition comprises an imaging characteristic of the projection optical system at the time of projecting the pattern image on the substrate.

19. The exposure method according to any one of claims 1 to 18, wherein the projection state of the pattern image projected under the moving condition at the time of exposing the substrate is measured prior to conducting exposure and the exposure condition is determined based on the measurement result.

20. The exposure method according to claim 19, wherein the pattern image is projected on a test substrate and wherein the measurement of the projection state comprises measuring the projection state of a plurality of pattern images formed on the test substrate.

21. An exposure apparatus for exposing a substrate by filling liquid into a light path space formed between a projection optical system and the substrate and projecting a pattern image on the substrate through the projection optical system and the liquid, comprising:
a movable member capable of holding and moving the substrate at an image plane side of the projection optical system; and
a storage device that pre-stores an exposure condition for projecting the pattern image on the substrate in a desired projection state in accordance with a moving condition of the substrate relative to the projection optical system.

22. The exposure apparatus according to claim 21, further comprising a control device that determines the exposure condition at the time of exposing the substrate based on the information stored in the storage device.

23. The exposure apparatus according to claim 21 or 22, wherein the exposure condition comprises a positional relationship between the substrate and the image plane formed through the projection optical system and the liquid, and further comprising a first adjustment device that adjusts the positional relationship.

24. The exposure apparatus according to any one of claims 21 to 23, wherein the exposure condition comprises an imaging characteristic of the projection optical system at the time of projecting the pattern image on the substrate, and further comprising a second adjustment device that adjusts the imaging characteristic.

25. The exposure apparatus according to any one of claims 21 to 24, wherein the exposure condition is determined so that the pattern image is not deteriorated by at least one of a temperature and a temperature distribution of the liquid varying with the moving condition of the substrate.

26. A device fabricating method that uses the exposure apparatus of any one of claims 21 to 25.
